(19) Europäisches Patentamt
European Patent Office
Office européen des brevets

(11) EP 4 425 551 A1

(12) EUROPEAN PATENT APPLICATION
published in accordance with Art. 153(4) EPC

(43) Date of publication:
04.09.2024 Bulletin 2024/36

(51) International Patent Classification (IPC):
H01L 27/00 (2006.01)

(21) Application number: 22942066.6

(22) Date of filing: 19.05.2022

(86) International application number:
PCT/CN2022/093768

(87) International publication number:
WO 2023/221024 (23.11.2023 Gazette 2023/47)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(71) Applicant: BOE Technology Group Co., Ltd.
Chaoyang District,
Beijing 100015 (CN)

(72) Inventors:
• WANG, Linlin
Beijing 100176 (CN)
• YAN, Guang
Beijing 100176 (CN)

(74) Representative: Studio Torta S.p.A.
Via Viotti, 9
10121 Torino (IT)

(54) LIGHT-EMITTING SUBSTRATE, DISPLAY PANEL, AND DISPLAY APPARATUS

(57) The disclosure provides a light-emitting substrate (100), a display panel (900) and a display device (1000). The light-emitting substrate (100) includes a plurality of light-emitting devices (110, 210, 310, 410, 510, 610, 710, 810) arranged in an array, each light-emitting device includes: a first electrode (121); a first light-emitting layer (131, 231, 331, 431, 531, 631, 731, 831) on the first electrode (121); a second light-emitting layer (132, 232, 332, 432, 532, 632, 732, 832) on a side of the first light-emitting layer (131, 231, 331, 431, 531, 631, 731, 831) away from the first electrode (121); a third light-emitting layer (133, 233, 333, 433, 533, 633, 733, 833) on a side of the second light-emitting layer (132, 232, 332, 432, 532, 632, 732, 832) away from the first electrode (121); a fourth light-emitting layer (134, 234, 334, 434, 534, 634, 734, 834) on a side of the third light-emitting layer (133, 233, 333, 433, 533, 633, 733, 833) away from the first electrode (121); and a second electrode (122) on a side of the fourth light-emitting layer (134, 234, 334, 434, 534, 634, 734, 834) away from the first electrode (121). Three light-emitting layers of the first light-emitting layer (131, 231, 331, 431, 531, 631, 731, 831), the second light-emitting layer (132, 232, 332, 432, 532, 632, 732, 832), the third light-emitting layer (133, 233, 333, 433, 533, 633, 733, 833), and the fourth light-emitting layer (134, 234, 334, 434, 534, 634, 734, 834) emit light of a first wavelength (L1), and a remaining light-emitting layer of the first light-emitting layer (131, 231, 331, 431, 531, 631, 731, 831), the second light-emitting layer (132, 232, 332, 432, 532, 632, 732, 832), the third light-emitting layer (133, 233, 333, 433, 533, 633, 733, 833), and the fourth light-emitting layer (134, 234, 334, 434, 534, 634, 734, 834) emits light of a second wavelength (L2), and the first wavelength is smaller than the second wavelength.

FIG. 2A

**Description**

TECHNICAL FIELD

The present disclosure relates to the field of optical technology, and in particular to a light-emitting substrate, a display panel comprising the light-emitting substrate, and a display device.

BACKGROUND

The importance of display devices has been increasing along with the development of multimedia, and various types of display devices have been developed. Display devices generally comprise two types of liquid crystal display devices and organic light-emitting diode display devices. Since the organic light-emitting diode display device has many advantages such as low power consumption, wide viewing angle, high brightness, high contrast, fast response, thin and light, etc., the organic light-emitting diode display device is attracting more and more attention.

SUMMARY

According to an aspect of the present disclosure, a light-emitting substrate is provided. The light-emitting substrate comprises a plurality of light-emitting devices arranged in an array. Each light-emitting device of the plurality of light-emitting devices comprises: a first electrode; a first light-emitting layer on the first electrode; a second light-emitting layer on a side of the first light-emitting layer away from the first electrode; a third light-emitting layer on a side of the second light-emitting layer away from the first electrode; a fourth light-emitting layer on a side of the third light-emitting layer away from the first electrode; and a second electrode on a side of the fourth light-emitting layer away from the first electrode. Three light-emitting layers of the first light-emitting layer, the second light-emitting layer, the third light-emitting layer, and the fourth light-emitting layer emit light of a first wavelength, a remaining light-emitting layer of the first light-emitting layer, the second light-emitting layer, the third light-emitting layer, and the fourth light-emitting layer except the three light-emitting layers emits light of a second wavelength, and the first wavelength is smaller than the second wavelength.

In some embodiments, a ratio of the first wavelength to the second wavelength is in a range of 0.82-0.84.

In some embodiments, the first wavelength and the second wavelength satisfy the following formula:

$$\frac{2nL}{\lambda_1} - \frac{2nL}{\lambda_2} = 1$$

wherein a plurality of layers are arranged between the first electrode and the second electrode, n is an effective refractive index of the plurality of layers, L is a first distance between the first electrode and the second electrode, $\lambda_1$ is the first wavelength, and $\lambda_2$ is the second wavelength.

In some embodiments, the first wavelength satisfies the following formula:

$$\sum_{1}^{M} n_i d_i = \frac{\lambda_1}{2}$$

wherein M layers are arranged between the first electrode and the second electrode, $n_i$ is an effective refractive index of the $i^{th}$ layer in the M layers, $d_i$ is a thickness of the $i^{th}$ layer in the M layers, $\lambda_1$ is the first wavelength, $1 \leq i \leq M$ and i is a positive integer.

In some embodiments, the light of the first wavelength emitted by the three light-emitting layers forms a first standing wave in the light-emitting device, and the light of the second wavelength emitted by the remaining light-emitting layer forms a second standing wave in the light-emitting device.

In some embodiments, a second distance between a surface of the first electrode facing the first light-emitting layer and a light-emitting center of the first light-emitting layer is greater than or equal to 100 nm.

In some embodiments, the first light-emitting layer, the second light-emitting layer, and the third light-emitting layer emit blue light, and the fourth light-emitting layer emits green light.

In some embodiments, the surface of the first electrode facing the first light-emitting layer is taken as a reference plane, the first light-emitting layer is at the second antinode of the first standing wave, the second light-emitting layer is at the third antinode of the first standing wave, the third light-emitting layer is at the fourth antinode of the first standing wave, and the fourth light-emitting layer is at the fourth antinode of the second standing wave.

In some embodiments, the second distance is 115-135 nm.

In some embodiments, the first light-emitting layer emits green light, and the second light-emitting layer, the third light-emitting layer, and the fourth light-emitting layer emit blue light.

In some embodiments, the surface of the first electrode facing the first light-emitting layer is taken as a reference plane, the first light-emitting layer is at the second antinode of the second standing wave, the second light-emitting layer is at the third antinode of the first standing wave, the third light-emitting layer is at the fourth antinode of the first standing wave, and the fourth light-emitting layer is at the fifth antinode of the first standing wave.

In some embodiments, the first light-emitting layer, the second light-emitting layer, and the fourth light-emitting layer emit blue light, and the third light-emitting layer emits green light.

In some embodiments, the surface of the first electrode facing the first light-emitting layer is taken as a reference plane, the first light-emitting layer is at the second antinode of the first standing wave, the second light-emitting layer is at the third antinode of the first standing wave, the fourth light-emitting layer is at the fifth antinode of the first standing wave, and a distance between the third light-emitting layer and the third antinode of the second standing wave is 10-30 nm.

In some embodiments, a second distance between a surface of the first electrode facing the first light-emitting layer and a light-emitting center of the first light-emitting layer is less than 100 nm.

In some embodiments, the first light-emitting layer, the second light-emitting layer, and the third light-emitting layer emit blue light, and the fourth light-emitting layer emits green light.

In some embodiments, the surface of the first electrode facing the first light-emitting layer is taken as a reference plane, the first light-emitting layer is at the first antinode of the first standing wave, the second light-emitting layer is at the third antinode of the first standing wave, the third light-emitting layer is at the fourth antinode of the first standing wave, and the fourth light-emitting layer is at the fourth antinode of the second standing wave.

In some embodiments, the first light-emitting layer, the second light-emitting layer, and the fourth light-emitting layer emit blue light, and the third light-emitting layer emits green light.

In some embodiments, the surface of the first electrode facing the first light-emitting layer is taken as a reference plane, the first light-emitting layer is at the first antinode of the first standing wave, the second light-emitting layer is at the third antinode of the first standing wave, the fourth light-emitting layer is at the fifth antinode of the first standing wave, and a distance between the third light-emitting layer and the third antinode of the second standing wave is 10-30 nm.

In some embodiments, the first light-emitting layer emits green light, and the second light-emitting layer, the third light-emitting layer, and the fourth light-emitting layer emit blue light.

In some embodiments, the surface of the first electrode facing the first light-emitting layer is taken as a reference plane, the first light-emitting layer is at the first antinode of the second standing wave, the second light-emitting layer is at the third antinode of the first standing wave, the third light-emitting layer is at the fourth antinode of the first standing wave, and the fourth light-emitting layer is at the fifth antinode of the first standing wave.

In some embodiments, a first distance between the first electrode and the second electrode is 500-550 nm.

In some embodiments, the first distance is equal to 5 times the distance between two adjacent antinodes of the first standing wave or 4 times the distance between two adjacent antinodes of the second standing wave.

In some embodiments, a thickness of each of the three light-emitting layers that emit the light of the first wavelength among the first light-emitting layer, the second light-emitting layer, the third light-emitting layer, and the fourth light-emitting layer is 20-25 nm, and a thickness of the light-emitting layer emitting the light of the second wavelength among the first light-emitting layer, the second light-emitting layer, the third light-emitting layer and the fourth light-emitting layer is 30-35 nm.

In some embodiments, the first electrode is an anode and the second electrode is a cathode, and the first electrode is reflective and the second electrode is transmissive and reflective.

In some embodiments, a full width at half maximum of both the light of the first wavelength and the light of the second wavelength satisfies the following formula:

$$FWHM = \frac{\lambda^2}{2L} \frac{(1-x^2)}{2Lx\pi}, \quad x = f(R_1, R_2)$$

wherein $\lambda$ is the first wavelength or the second wavelength, L is a first distance between the first electrode and the second electrode, $R_1$ is a reflectivity of the second electrode, $R_2$ is a reflectivity of the first electrode, x is a function of $R_1$ and $R_2$.

In some embodiments, $x = (R_1 R_2)^{1/4}$.

In some embodiments, each light-emitting device of the plurality of light-emitting devices further comprises a first charge generation layer between the first light-emitting layer and the second light-emitting layer, a second charge generation layer between the second light-emitting layer and the third light-emitting layer, and a third charge generation layer between the third light-emitting layer and the fourth light-emitting layer.

In some embodiments, the light-emitting substrate further comprises a fifth light-emitting layer between the fourth light-emitting layer and the second electrode, wherein the fifth light-emitting layer emits the light of the first wavelength or the light of the second wavelength.

In some embodiments, the light-emitting device is an organic light-emitting diode.

According to another aspect of the present disclosure, there is provided a display panel. The display panel comprises the light-emitting substrate described in any one of the preceding embodiments and a plurality of sub-pixels arranged in an array, each of the plurality of sub-pixels is provided with the light-emitting device.

In some embodiments, the display panel further comprises a wavelength conversion layer on a side of the second electrode away from the first electrode. The wavelength conversion layer comprises a plurality of first wavelength conversion patterns and a plurality of second wavelength conversion patterns. The plurality of sub-pixels comprise a plurality of first sub-pixels, a plurality of second sub-pixels and a plurality of third sub-pixels. Each of the plurality of first sub-pixels is provided with a first wavelength conversion pattern, the first wavelength conversion pattern is configured to convert the light of the first wavelength and the light of the second wavelength emitted by the light-emitting device in the first sub-pixel into light of a third wavelength; and each of the plurality of second sub-pixels is provided with a second wavelength conversion pattern, the second wavelength conversion pattern is configured to convert the light of the first wavelength emitted by the light-emitting device in the second sub-pixel into the light of the second wavelength.

In some embodiments, a material of the wavelength conversion layer comprises quantum dots.

In some embodiments, the display panel further comprises a color filter on a side of the wavelength conversion layer away from the first electrode. The color filter comprises a plurality of first color filters, a plurality of second color filters and a plurality of third color filters. Each of the plurality of first sub-pixels is provided with a first color filter, the first color filter is configured to allow transmission of the light of the third wavelength; each of the plurality of second sub-pixels is provided with a second color filter, the second color filter is configured to allow transmission of the light of the second wavelength; and each of the plurality of third sub-pixels is provided with a third color filter, the third color filter is configured to allow transmission of the light of the first wavelength.

According to still another aspect of the present disclosure, a display device is provided. The display device comprises the light-emitting substrate described in any of the preceding embodiments or the display panel described in any of the preceding embodiments; a driving circuit electrically connected to the light-emitting substrate and configured to provide a driving signal to the display device; and a power supply circuit electrically connected to the light-emitting substrate and configured to provide a voltage signal to the display device.

BRIEF DESCRIPTION OF THE DRAWINGS

In order to more clearly describe the technical solutions in the embodiments of the present disclosure, the drawings that need to be used in the embodiments will be briefly introduced in the following. Obviously, the drawings in the following description are only some embodiments of the present disclosure. Those of ordinary skill in the art can also obtain other drawings based on these drawings without making creative efforts.

FIG. 1A schematically illustrates a plan view of a light-emitting substrate according to an embodiment of the present disclosure;

FIG. 1B schematically illustrates a cross-sectional view of a light-emitting device of the light-emitting substrate of FIG. 1A;

FIG. 2A schematically illustrates a cross-sectional view of a light-emitting device according to an embodiment of the present disclosure;

FIG. 2B illustrates a spectrum diagram of light emitted by light-emitting devices with different stacked structures;

FIG. 2C illustrates a spectrum diagram of light emitted by light-emitting devices with different stacked structures and converted by quantum dots;

FIG. 3A schematically illustrates a cross-sectional view of a light-emitting device according to another embodiment of the present disclosure;

FIG. 3B illustrates a spectrum diagram of light emitted by light-emitting devices with different stacked structures;

FIG. 3C illustrates a spectrum diagram of light emitted by light-emitting devices with different stacked structures and converted by quantum dots;

FIG. 4A schematically illustrates a cross-sectional view of a light-emitting device according to another embodiment of the present disclosure;

FIG. 4B illustrates a spectrum diagram of light emitted by light-emitting devices with different stacked structures;

FIG. 4C illustrates a spectrum diagram of light emitted by light-emitting devices with different stacked structures and converted by quantum dots;

FIG. 5A schematically illustrates a cross-sectional view of a light-emitting device according to another embodiment of the present disclosure;

FIG. 5B illustrates a spectrum diagram of light emitted by light-emitting devices with different stacked structures;

FIG. 5C illustrates a spectrum diagram of light emitted by light-emitting devices with different stacked structures and converted by quantum dots;

FIG. 6A schematically illustrates a cross-sectional view of a light-emitting device according to another embodiment of the present disclosure;

FIG. 6B illustrates a spectrum diagram of light emitted by light-emitting devices with different stacked structures;

FIG. 6C illustrates a spectrum diagram of light emitted by light-emitting devices with different stacked structures and converted by quantum dots;

FIG. 7A schematically illustrates a cross-sectional view of a light-emitting device according to another embodiment of the present disclosure;

FIG. 7B illustrates a spectrum diagram of light emitted by light-emitting devices with different stacked structures;

FIG. 7C illustrates a spectrum diagram of light emitted by light-emitting devices with different stacked structures and converted by quantum dots;

FIG. 8A schematically illustrates a cross-sectional view of a light-emitting device according to another embodiment of the present disclosure;

FIG. 8B illustrates a graph of the relationship between the power consumption of the light-emitting device and the number of stacks of the light-emitting layers in the light-emitting device;

FIG. 9A schematically illustrates a plan view of a display panel according to an embodiment of the present disclosure;

FIG. 9B schematically illustrates a cross-sectional view of the display panel taken along the line AA' of FIG 9A;

FIG. 9C schematically illustrates a partial structural diagram of the display panel in FIG. 9B;

FIG. 9D illustrates a graph of the absorption spectrum of the quantum dots; and

FIG. 10 schematically illustrates a block diagram of a display device according to an embodiment of the present disclosure.

## DETAILED DESCRIPTION OF THE DISCLOSURE

The technical solutions in the embodiments of the present disclosure will be clearly and completely described with reference to the drawings in the embodiments of the present disclosure. In the drawings, the same or similar reference numerals are used to denote the same or similar components. Apparently, the described embodiments are only some, but not all, of the embodiments of the present disclosure. Based on the embodiments of the present disclosure, all other embodiments obtained by those of ordinary skill in the art without making creative efforts belong to the protection scope of the present disclosure.

It can be understood that the various drawings in the embodiments of the present disclosure are only used to schematically illustrate the structures of the various components, the dimensions of the various components in the drawings are not drawn to scale, and their relative positional relationship does not necessarily completely correspond to the actual position. In the drawings, the scale of some regions and layers may be exaggerated for clarity.

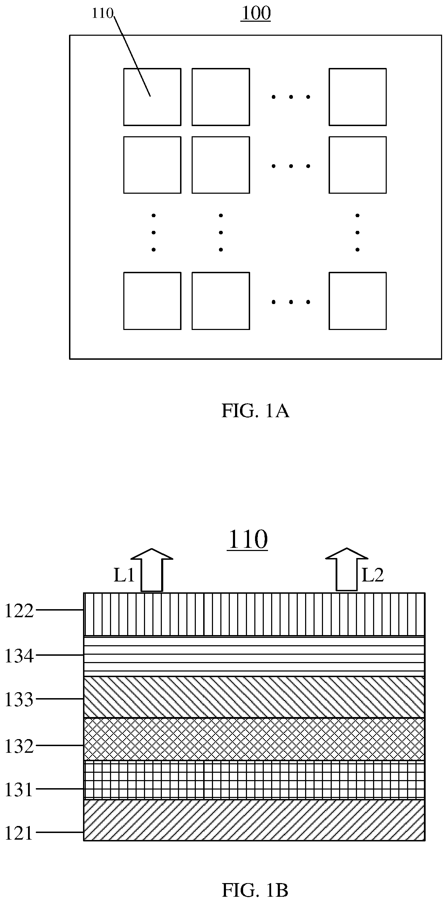

Embodiments of the present disclosure provide a light-emitting substrate. FIG. 1A schematically illustrates a plan view of a light-emitting substrate 100 comprising a plurality of light-emitting devices 110 arranged in an array. Generally, the plurality of light-emitting devices 110 are arranged at uniform intervals. For the purpose of brevity and clarity, FIG. 1A illustrates several light-emitting devices 110, and uses an ellipsis "..." to represent many light-emitting devices 110 that are not illustrated, but this does not mean that the light-emitting substrate 100 only comprises the light-emitting devices 110 as illustrated in the figure. As known by those skilled in the art, the light-emitting substrate 100 may comprise a large number of light-emitting devices 110.

FIG. 1B illustrates a schematic structural view of a light-emitting device 110 of the light-emitting substrate 100 in FIG. 1A. With reference to FIGS. 1A and 1B, the light-emitting substrate 100 comprises a plurality of light-emitting devices 110 arranged in an array, and each light-emitting device 110 comprises: a first electrode 121; a first light-emitting layer 131 on the first electrode 121; a second light-emitting layer 132 on a side of the first light-emitting layer 131 away from the first electrode 121; a third light-emitting layer 133 on a side of the second light-emitting layer 132 away from the first electrode 121; a fourth light-emitting layer 134 on a side of the third light-emitting layer 133 away from the first electrode 121; and a second electrode 122 on a side of the fourth light-emitting layer 134 away from the first electrode 121. Three light-emitting layers of the first light-emitting layer 131, the second light-emitting layer 132, the third light-emitting layer 133, and the fourth light-emitting layer 134 emit light L1 of the first wavelength, a remaining light-emitting layer of the first light-emitting layer 131, the second light-emitting layer 132, the third light-emitting layer 133, and the fourth light-emitting layer 134 except the three light-emitting layers emit light L2 of the second wavelength, and the first wavelength is smaller than the second wavelength.

The inventors of the present application found that the power consumption of a light-emitting device is related to the number of layers of the stacked light-emitting layers in the light-emitting device, and choosing an appropriate number of stacked layers is helpful to reduce the power consumption of the light-emitting device. Through the calculation of the color gamut of power consumption, the inventors of the present application propose that when the number of layers of the stacked light-emitting layers in the light-emitting device is four, the power consumption of the light-emitting device is relatively low. Therefore, in the embodiments of the present disclosure, four light-emitting layers 131, 132, 133, 134 stacked in sequence are provided in each light-emitting device 110, thereby helping to reduce power consumption of the light-emitting device 110. Further, the inventors also found that compared to the four light-emitting layers all emit light of the first wavelength, making three light-emitting layers among the four light-emitting layers 131, 132, 133, 134 emit light L1 of the first wavelength and the remaining one light-emitting layer emit light L2 of the second wavelength is better, since when it is desired to obtain light of the second wavelength by the light-emitting device 110, the light L1 of first wavelength emitted by the light-emitting device 110 can be converted into the light of second wavelength, the converted light of second wavelength and the light L2 of second wavelength emitted by the light-emitting device 110 are added together to form the finally obtained light of second wavelength. In this way, not only the high brightness and high intensity requirements of the emitted light of the light-emitting device 110 can be realized by the narrow full width at half maximum (FWHM) emission spectrum characteristic of the light L1 of first wavelength, but also the light L2 of second wavelength emitted by the light-emitting device 110 can also be used as a supplementary light source to increase the total amount of light of the second wavelength, thereby improving the brightness of the light of second wavelength that is finally obtained.

In some embodiments, the ratio of the first wavelength to the second wavelength is in the range of 0.82-0.84.

In some embodiments, the light L1 of first wavelength may be blue light, and the light L2 of second wavelength may be green light. Of course, in alternative embodiments, the light L1 of first wavelength and the light L2 of second wavelength may also be lights of other appropriate colors, but it needs to be satisfied that the first wavelength is smaller than the second wavelength.

In some embodiments, the first wavelength and the second wavelength satisfy the following formula:

$$\frac{2nL}{\lambda_1} - \frac{2nL}{\lambda_2} = 1 \quad,$$

where a plurality of layers are arranged between the first electrode 121 and the second electrode 122, n is an effective refractive index of the plurality of layers, L is a first distance between the first electrode 121 and the second electrode 122, $\lambda_1$ is the first wavelength, and $\lambda_2$ is the second wavelength. When light L1 of the first wavelength is blue light and light L2 of the second wavelength is green light, $\lambda_1$ is the wavelength of the blue light, and $\lambda_2$ is the wavelength of the green light. It should be pointed out that, in addition to the first light-emitting layer 131, the second light-emitting layer 132, the third light-emitting layer 133, and the fourth light-emitting layer 134, other functional layers may also be arranged between the first electrode 121 and the second electrode 122 as required, for example, the charge generation layer, the hole injection layer, the hole transport layer, the electron injection layer, the electron transport layer, etc. When the above-mentioned four light-emitting layers and multiple functional layers are arranged between the first electrode 121 and the second electrode 122, n refers to the effective refractive index of all layers arranged between the first electrode 121 and the second electrode 122.

In some embodiments, the first wavelength satisfies the following formula:

$$\sum_{1}^{M} n_i d_i = \frac{\lambda_1}{2} \quad,$$

where M layers are arranged between the first electrode 121 and the second electrode 122, $n_i$ is an effective refractive index of the $i^{th}$ layer in the M layers, $d_i$ is a thickness of the $i^{th}$ layer in the M layers, $\lambda_1$ is the first wavelength, $1 \leq i \leq M$ and i is a positive integer. When the light L1 of first wavelength is blue light, $\lambda_1$ is the wavelength of blue light.

It should be pointed out that the light-emitting substrate 100 provided by the embodiments of the present disclosure may be applied to various appropriate fields, comprising but not limited to the display field, the vehicle field, the medical field, and the like. For example, the light-emitting substrate 100 may be used in any suitable products or components such as mobile phones, tablet computers, televisions, monitors, notebook computers, digital photo frames, navigators, e-books, vehicle touch panels, and medical testing equipment.

Various possible arrangements of the light-emitting devices 110 of the light-emitting substrate 100 are introduced below. In the following multiple embodiments, various possible arrangements of the light-emitting devices will be introduced by taking the blue light emitted by the light-emitting device as the light L1 of first wavelength and the green light emitted by the light-emitting device as the light L2 of second wavelength as an example.

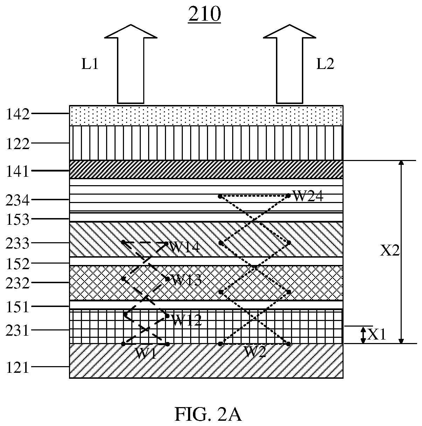

FIG. 2A illustrates an arrangement of a light-emitting device 210. As illustrated in FIG. 2A, the light-emitting device 210 comprises: a first electrode 121; a first light-emitting layer 231 on the first electrode 121; a second light-emitting layer 232 on a side of the first light-emitting layer 231 away from the first electrode 121; a third light-emitting layer 233 on a side of the second light-emitting layer 232 away from the first electrode 121; a fourth light-emitting layer 234 on a side of the third light-emitting layer 233 away from the first electrode 121; and a second electrode 122 on a side of the fourth light-emitting layer 234 away from the first electrode 121. The first light-emitting layer 231, the second light-emitting layer 232 and the third light-emitting layer 233 emit blue light L1, while the fourth light-emitting layer 234 emits green light L2. In some embodiments, the light-emitting device 210 may be an organic light-emitting diode, and correspondingly, the first light-emitting layer 231, the second light-emitting layer 232, the third light-emitting layer 233 and the fourth light-emitting layer 234 are organic light-emitting layers.

The first electrode 121 may be a reflective anode, and the second electrode 122 may be a transmissive and reflective cathode, thus, the first electrode 121 and the second electrode 122 may form an optical resonant cavity. The light-emitting device 210 comprising the first electrode 121 and the second electrode 122 is a top emission device, that is, the light-emitting device 210 emits blue light L1 and green light L2 from the side of the second electrode 122 away from the first electrode 121. The first electrode 121 and the second electrode 122 may use various appropriate materials, which are not specifically limited in the embodiments of the present disclosure. In some embodiments, the material of the first electrode 121 may be ITO/Ag/ITO, the thickness of the Ag layer is about 1000 Å, and the thickness of each layer of ITO is about 80-150 Å, for example, an ITO/Ag/ITO layer may be formed by a sputtering process. In some embodiments, the material of the second electrode 122 may be a transflective metal, such as Ag, Mg, Cu, Al, Pt, Pd, Au, Ni, Nd, Ir, Cr, Li, Ca, LiF/Ca, LiF/Al, Mo, Ti, etc. In some embodiments, the thickness of the second electrode 122 may be approximately 100-150 Å.

In the embodiment where the first electrode 121 is a reflective anode and the second electrode 122 is a transmissive and reflective cathode, the full width at half maximum (FWHM) of both the blue light L1 and the green light L2 emitted by the light-emitting device 210 satisfies the formula:

$$FWHM = \frac{\lambda^2}{2L}\frac{(1-x^2)}{2Lx\pi}, \quad x = f(R_1, R_2)$$

where $\lambda$ is the wavelength of blue light L1 or green light L2, L is the first distance between the first electrode 121 and the second electrode 122, $R_1$ is the reflectivity of the second electrode 122, $R_2$ is the reflectivity of the first electrode

$$FWHM = \frac{\lambda^2}{2L}\frac{\left(1-\sqrt{R_1 R_2}\right)}{2L\pi(R_1 R_2)^{1/4}}$$

121, and x is a function of $R_1$ and $R_2$. In an example, $x = (R_1 R_2)^{1/4}$, in this case,

. In the wavelength curve of blue light L1, there are two points on the curve, and the values corresponding to the ordinates of the two points are equal and equal to half of the peak value of the curve, and the distance between these two points is the FWHM of the blue light L1. In the wavelength curve of green light L2, there are two points on the curve, and the values corresponding to the ordinates of the two points are equal and equal to half of the peak value of the curve, and the distance between these two points is the FWHM of the green light L2.

As illustrated in FIG. 2A, the blue light L1 emitted by the first light-emitting layer 231, the second light-emitting layer 232, and the third light-emitting layer 233 forms a first standing wave W1 in the resonant cavity of the light-emitting device 210, and the green light L2 emitted by the fourth light-emitting layer 234 forms a second standing wave W2 in the resonant cavity of the light-emitting device 210. As known to those skilled in the art, a standing wave comprises nodes and antinodes, a node is the point of the standing wave with the smallest amplitude, and an antinode is the point of the standing wave with the largest amplitude. A wave node is also called a node, and a wave loop is also called an antinode.

The blue light L1 emitted by the light-emitting layers 231, 232, and 233 in the light-emitting device 210 forms the first standing wave W1 between the first electrode 121 and the second electrode 122, and the length $T_B$ corresponding to one period of the antinode of the first standing wave W1 can be roughly considered equal to $\lambda_B/(2*n)$, where $\lambda_B$ is the

wavelength of the blue light L1, and n is the effective refractive index of the medium between the first electrode 121 and the second electrode 122. It can be understood that $\lambda_B$ is a value within the wavelength range of blue light, and the value of n may be changed due to the difference of the medium between the first electrode 121 and the second electrode 122. Similarly, the green light L2 emitted by the light-emitting layer 234 in the light-emitting device 210 forms the second standing wave W2 between the first electrode 121 and the second electrode 122, and the length $T_G$ corresponding to one period of the antinode of the first standing wave W2 can be roughly considered equal to $\lambda_G/(2*n)$, where $\lambda_G$ is the wavelength of the green light L2, and n is the effective refractive index of the medium between the first electrode 121 and the second electrode 122. It can be understood that $\lambda_G$ is a value within the wavelength range of green light, and the value of n may be changed due to the difference of the medium between the first electrode 121 and the second electrode 122.

The blue light emitted by the first light-emitting layer 231, the second light-emitting layer 232, and the third light-emitting layer 233 have substantially the same peak wavelength, and the ratio of the peak wavelength of the blue light to the peak wavelength of the green light emitted by the fourth light-emitting layer 234 is in the range of 0.82-0.84. By making the ratio of the peak wavelength of the blue light to the peak wavelength of the green light in the range of 0.82-0.84, the position of the resonant cavity of the blue light can be closer to the position of the resonant cavity of the green light, so that the light-emitting efficiency of the light-emitting device 210 can be maximized.

As illustrated in FIG. 2A, taking the surface of the first electrode 121 facing the first light-emitting layer 231 as a reference plane, the first light-emitting layer 231 emitting blue light is at the second antinode W12 of the first standing wave W1, the second light-emitting layer 232 emitting blue light is at the third antinode W13 of the first standing wave W1, the third light-emitting layer 233 emitting blue light is at the fourth antinode W14 of the first standing wave W1, and the fourth light-emitting layer 234 emitting green light is at the fourth antinode W24 of the second standing wave W2. Since the light-emitting layers 231, 232, 233 and 234 are all at the antinode positions of the corresponding standing waves, the blue light L1 emitted by the blue light-emitting layers 231, 232, and 233 can produce constructive interference to enhance the light intensity of the blue light L1, and the green light L2 emitted by the green light-emitting layer 234 can produce constructive interference to enhance the light intensity of the green light L2. Further, the fourth light-emitting layer 234 that emits green light is at the fourth antinode W24 of the second standing wave W2, it is verified that this position is the best resonance position of the green light L2, and the brightness of the green light L2 emitted by the fourth light-emitting layer 234 at this position is the highest.

For ease of description, embodiments of the present disclosure define a second distance X1, which is the distance between the surface of the first electrode 121 facing the first light-emitting layer 231 and the light-emitting center of the first light-emitting layer 231. Herein, the location of "the light-emitting center of the light-emitting layer" can be simply understood as the plane where the light-emitting layer is half its thickness, and the plane is parallel to the extending direction of the light-emitting layer. Therefore, the second distance X1 can be simply understood as the distance between the surface of the first electrode 121 facing the first light-emitting layer 231 and the position where half the thickness of the first light-emitting layer 231. In some embodiments, the second distance X1 is greater than or equal to 100 nm. In the example of FIG. 2A, the second distance X1 is 115-135 nm, such as 115 nm, 120 nm, 125 nm, 130 nm, 135 nm, and so on. In an example, the second distance X1 is equal to 125 nm. If the second distance X1 is small, a surface plasmon polariton effect (spp) occurs near the interface of the first electrode 121 and the first light-emitting layer 231, which reduces the luminous efficiency of the emitted light of the light emitting device 210. Therefore, an appropriate value of the second distance X1 is beneficial to promote the luminous efficiency of the emitted light of the light emitting device 210. Moreover, according to the period length $T_B=\lambda_B/(2*n)$ of the antinode of the first standing wave W1 (for example, when $\lambda_B$=440 nm and n=1.8, $T_B$ is about 122 nm), when the second distance X1 is greater than or equal to 100 nm (for example, 122 nm), the first light-emitting layer 231 may be at the second antinode W12 of the first standing wave W1, so that the blue light emitted by the first light-emitting layer 231 can produce constructive interference to enhance the light intensity of the blue light L1.

In the example of FIG. 2A, the distance between the light-emitting center of the second light-emitting layer 232 and the surface of the first electrode 121 facing the first light-emitting layer 231 is 225-255 nm, such as 225 nm, 230 nm, 235 nm, 240 nm, 245 nm, 250 nm, 255 nm, etc.; the distance between the light-emitting center of the third light-emitting layer 233 and the surface of the first electrode 121 facing the first light-emitting layer 231 is 340-370 nm, such as 340 nm, 345 nm, 350 nm, 355 nm, 360 nm, 365 nm, 370 nm, etc.; the distance between the light-emitting center of the fourth light-emitting layer 234 and the surface of the first electrode 121 facing the first light-emitting layer 231 is 450-480 nm, such as 450 nm, 455 nm, 460 nm, 465 nm, 470 nm, 475 nm, 480 nm, etc.

It can be understood that the distance between the light-emitting center of each light-emitting layer and the surface of the first electrode 121 facing the first light-emitting layer 231 corresponds to the position of the antinode of the standing wave where the light-emitting layer is located, because only when the distance between the light-emitting center of each light-emitting layer and the surface of the first electrode 121 facing the first light-emitting layer 231 is designed as a reasonable value, can each light-emitting layer be at the corresponding antinode position. For example, as an example, when $\lambda_B$ takes a value of 440 nm and n takes a value of 1.8, $T_B$ is about 122 nm, that is, the distance between two adjacent antinodes of the first standing wave W1 is 122 nm. In this case, when the distance between the light-emitting center of the first light-emitting layer 231 and the surface of the first electrode 121 facing the first light-emitting layer 231 is 115-135 nm (for example, 122 nm), the first light-emitting layer 231 can be located at the second antinode W12 of the first standing wave W1. When the distance between the light-emitting center of the second light-emitting layer 232 and the surface of the first electrode 121 facing the first light-emitting layer 231 is 225-255 nm (for example, 244 nm), the second light-emitting layer 232 can be located at the third antinode W13 of the first standing wave W1. When the distance between the light-emitting center of the third light-emitting layer 233 and the surface of the first electrode 121 facing the first light-emitting layer 231 is 340-370 nm (for example, 366 nm), the third light-emitting layer 233 can be located at the fourth antinode W14 of the first standing wave W1. For example, as an example, when $\lambda_G$ takes a value of 540 nm and n takes a value of 1.8, $T_G$ is equal to 150 nm, in this case, when the distance between the light-emitting center of the fourth light-emitting layer 234 and the surface of the first electrode 121 facing the first light-emitting layer 231 is 450-480 nm (for example, 450 nm), the fourth light-emitting layer 234 can be located at the fourth antinode W24 of the second standing wave W2.

In the embodiment of the present application, by making the first light-emitting layer 231, the second light-emitting layer 232 and the third light-emitting layer 233 of the light-emitting device 210 respectively be at the second, the third and the fourth antinodes of the first standing wave W1, the blue light emitted by them can produce constructive interference to enhance the light intensity of the blue light L1; by making the fourth light-emitting layer 234 of the light-emitting device 210 at the fourth antinode W24 of the second standing wave W2, the green light L2 emitted by the fourth light-emitting layer 234 can be at an optimal resonance position, so that the brightness of the green light L2 is the highest; by making the ratio of the peak wavelength of the blue light L1 emitted by the first light-emitting layer 231, the second light-emitting layer 232 and the third light-emitting layer 233 to the peak wavelength of the green light L2 emitted by the fourth light-emitting layer 234 be in the range of 0.82-0.84, the position of the resonant cavity of the blue light is close to the position of the resonant cavity of the green light, so that the light-emitting efficiency of the light-emitting device 210 can be maximized. When it is desired to obtain green light through the light-emitting device 210, the blue light L1 emitted by the light-emitting device 210 can be converted into green light, and the converted green light and the green light L2 emitted by the light-emitting device 210 are added as the resulted green light. In this way, not only the high brightness and high intensity requirements of the emitted light of the light-emitting device 210 can be realized by using the emission spectrum characteristics of the narrow FWHM of the blue light L1, but also the green light L2 emitted by the light-emitting device 210 can be used as a supplementary light source, so as to increase the total amount of green light, thereby improving the brightness of the resulted green light. It is verified that, the brightness of the resulted green light obtained by converting the light emitted by the light-emitting device 210 plus the green light L2, is significantly higher than the brightness of green light obtained by converting light emitted by a conventional light-emitting device comprising four blue-emitting layers. Moreover, when it is desired to obtain red light by the light-emitting device 210, the blue light L1 and the green light L2 emitted by the light-emitting device 210 may also be converted into red light. It is verified that, the brightness of red light obtained by converting the light emitted by the light-emitting device 210 is also significantly higher than the brightness of red light obtained by converting the light emitted by a conventional light-emitting device comprising four blue light-emitting layers.

Embodiments of the present disclosure also define a first distance X2, which is the distance between the first electrode 121 and the second electrode 122, that is, the distance between the surface of the first electrode 121 facing the first light-emitting layer 231 and the surface of the second electrode 122 facing the first electrode 121, the first distance X2 is the cavity length of the resonant cavity of the light-emitting device 210. In some embodiments, the first distance X2 is 500-550 nm, such as 500 nm, 510 nm, 520 nm, 530 nm, 540 nm, 550 nm, and so on. In an example, the first distance X2 is equal to 5 times the distance between two adjacent antinodes of the first standing wave W1 (i.e. $T_B$), or 4 times the distance between two adjacent antinodes of the second standing wave W2 (i.e. $T_G$). The first distance X2 can make the difference between the optimal resonant cavity positions of the blue light L1 and the green light L2 very small or even negligible, so that the light-emitting efficiency of the light-emitting device 210 can be maximized. Moreover, considering the uniformity of the evaporation process during the manufacturing process, the first distance X2 should not be selected too large.

In some embodiments, the thicknesses of the first light-emitting layer 231, the second light-emitting layer 232, and the third light-emitting layer 233 are each about 20-25 nm, and the thickness of the fourth light-emitting layer 234 is about 30-35 nm. The first light-emitting layer 231, the second light-emitting layer 232, the third light-emitting layer 233 and the fourth light-emitting layer 234 may use various appropriate materials, for example, an organic material or an inorganic material, the embodiments of the present disclosure do not specifically limit the material of the light-emitting layer. When the material of the light-emitting layer is an organic material, the light-emitting device 210 may be an organic light-emitting diode.

Continuing to refer to FIG. 2A, the light-emitting device 210 may further comprise a first charge generation layer 151 between the first light-emitting layer 231 and the second light-emitting layer 232, a second charge generation layer 152 between the second light-emitting layer 232 and the third light-emitting layer 233, and a third charge generation layer 153 between the third light-emitting layer 233 and the fourth light-emitting layer 234. In some embodiments, each of the first charge generation layer 151, the second charge generation layer 152, and the third charge generation layer 153 may comprise an n-type charge generation layer and a p-type charge generation layer. The first charge generation layer 151 can provide charges to the first light-emitting layer 231 and the second light-emitting layer 232, thereby controlling the charge balance between the first light-emitting layer 231 and the second light-emitting layer 232; the second charge generation layer 152 may provide charges to the second light-emitting layer 232 and the third light-emitting layer 233, thereby controlling the charge balance between the second light-emitting layer 232 and the third light-emitting layer 233; the third charge generation layer 153 may provide charges to the third light-emitting layer 233 and the fourth light-emitting layer 234, thereby controlling the charge balance between the third light-emitting layer 233 and the fourth light-emitting layer 234. By arranging these charge generation layers, it is helpful to improve the light-emitting efficiency of the light-emitting device 210 and to reduce the driving voltage of the light-emitting device 210.

As illustrated in the figure, the light-emitting device 210 may further comprise a charge injection layer 141 between the fourth light-emitting layer 234 and the second electrode 122, and a CPL layer (capping layer) 142 on the side of the second electrode 122 away from the first electrode 121. Generally, when the light emitted by the light-emitting layer of the light-emitting device 210 emits by passing through the second electrode 122, there is a surface plasmon polariton effect (spp) near the interface between the metal second electrode 122 and the medium. This effect will decrease the light-emitting efficiency, but the existence of the CPL layer 142 can suppress this negative effect, thereby helping to improve the light-emitting efficiency of the light-emitting device 210.

It should be noted that, although not illustrated in FIG. 2A, one or more of a hole injection layer, a hole transport layer, an electron injection layer, and an electron transport layer may also be arranged as required between the first light-emitting layer 231, the second light-emitting layer 232, the third light-emitting layer 233 and the fourth light-emitting layer 234, which are not limited in the embodiments of the present disclosure.

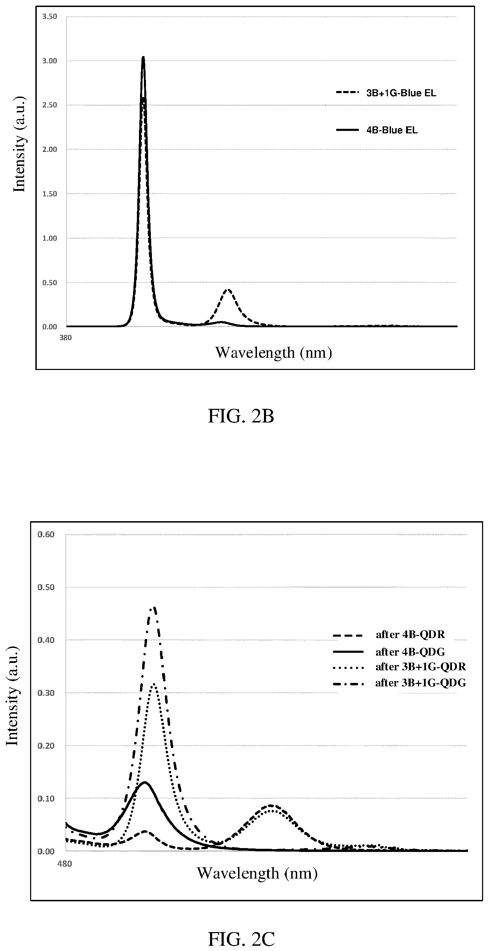

FIG. 2B illustrates a comparison of spectrum diagrams of the emitted light before being converted by the wavelength conversion layer, wherein the curve "4B-Blue EL" represents the spectral diagram of the emitted light of a conventional light-emitting device comprising four blue light-emitting layers, and the curve "3B+1G-Blue EL" represents the spectral diagram of the emitted light of the light-emitting device 210 illustrated in FIG. 2A of the present application. It can be seen from FIG. 2C that the curve 3B+1G-Blue EL has two peaks, the peak with higher intensity has a shorter wavelength, which is the peak wavelength corresponding to the blue light L1; the peak with lower intensity has a longer wavelength, which is the peak wavelength corresponding to the green light L2. Moreover, the curve 3B+1G-Blue EL only shows one peak of blue light, which indicates that the blue light respectively emitted by the first light-emitting layer 231, the second light-emitting layer 232 and the third light-emitting layer 233 has substantially the same peak wavelength.

FIG. 2C illustrates a comparison of spectrum diagrams of the emitted light after being converted by the wavelength conversion layer, wherein the curve "after 4B-QDR" represents a spectrum diagram of the light that is emitted by a conventional light-emitting device comprising four blue light-emitting layers and converted by red quantum dots, the curve "after 4B-QDG" represents a spectrum diagram of the light that is emitted by a conventional light-emitting device comprising four blue light-emitting layers and converted by green quantum dots, the curve "after 3B+1G-QDR" represents a spectrum diagram of the light that is emitted by the light-emitting device 210 illustrated in FIG. 2A of the present application and converted by red quantum dots, and the curve "after 3B+1G-QDG" represents a spectrum diagram of the light that is emitted by the light-emitting device 210 illustrated in FIG. 2A of the present application and converted by green quantum dots. Comparing the curves "after 4B-QDR" and "after 3B+1G-QDR", it can be seen that, compared with the conventional light-emitting device comprising four blue light-emitting layers, the intensity of the emitted red light is improved after the light emitted by the light-emitting device 210 illustrated in FIG. 2A is converted by red quantum dots. Comparing the curves "after 4B-QDG" and "after 3B+1G-QDG", it can be seen that, compared with the conventional light-emitting device comprising four blue light-emitting layers, the intensity of the emitted green light is significantly improved after the light emitted by the light-emitting device 210 illustrated in FIG. 2A is converted by green quantum dots. Moreover, the significance of the increase in green light intensity is greater than that of red light intensity.

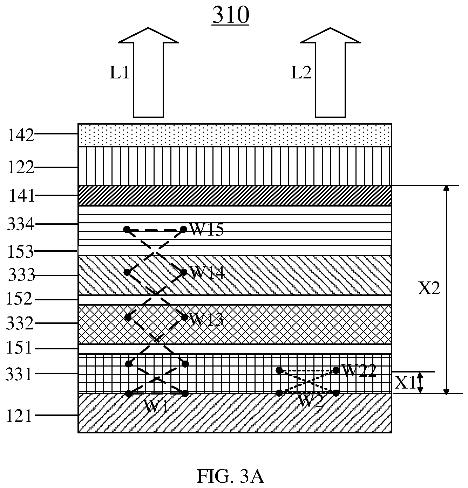

FIG. 3A illustrates an arrangement of a light-emitting device 310 which is a variant of the light-emitting device 210. The light-emitting device 310 illustrated in FIG. 3A has substantially the same configuration as the light-emitting device 210 illustrated in FIG. 2A, and thus the same reference numerals are used to designate the same components. Therefore, for the specific structures and functions of components with the same reference numerals in FIG. 3A as those in FIG. 2A, reference may be made to the description of FIG. 2A, and details will not be repeated here. For the sake of brevity, only the differences between the light-emitting device 310 and the light-emitting device 210 are introduced below.

As illustrated in FIG. 3A, the light-emitting device 310 comprises: a first electrode 121; a first light-emitting layer 331 on the first electrode 121; a second light-emitting layer 332 on the side of the first light-emitting layer 331 away from the first electrode 121; a third light-emitting layer 333 on the side of the second light-emitting layer 332 away from the first electrode 121; a fourth light-emitting layer 334 on the side of the third light-emitting layer 333 away from the first electrode 121; and a second electrode 122 on the side of the fourth light-emitting layer 334 away from the first electrode 121. The second light-emitting layer 332, the third light-emitting layer 333 and the fourth light-emitting layer 334 emit blue light L1, and the first light-emitting layer 331 emits green light L2. The blue light emitted by the second light-emitting layer 332, the third light-emitting layer 333 and the fourth light-emitting layer 334 has substantially the same peak wavelength, and the ratio of the peak wavelength of the blue light to the peak wavelength of the green light emitted by the first light-emitting layer 331 is in the range of 0.82-0.84. By making the ratio of the peak wavelength of the blue light to the peak wavelength of the green light within the range of 0.82-0.84, the position of the resonant cavity of the blue light can be closer to the position of the resonant cavity of the green light, so that the light-emitting efficiency of the light-emitting device 310 can be maximized.

The second distance X1 between the light-emitting center of the first light-emitting layer 331 and the surface of the first electrode 121 facing the first light-emitting layer 331 is greater than or equal to 100 nm. In the example of FIG. 3A, the second distance X1 is 130-150 nm, such as 130 nm, 135 nm, 140 nm, 145 nm, 150 nm, and so on. In an example, the second distance X1 is equal to 140 nm. The distance between the light-emitting center of the second light-emitting layer 332 and the surface of the first electrode 121 facing the first light-emitting layer 331 is 225-255 nm, such as 225 nm, 230 nm, 235 nm, 240 nm, 245 nm, 250 nm, 255 nm, etc. The distance between the light-emitting center of the third light-emitting layer 333 and the surface of the first electrode 121 facing the first light-emitting layer 331 is 340-370 nm, such as 340 nm, 345 nm, 350 nm, 355 nm, 360 nm, 365 nm, 370 nm, etc. The distance between the light-emitting center of the fourth light-emitting layer 334 and the surface of the first electrode 121 facing the first light-emitting layer 331 is 450-480 nm, such as 450 nm, 455 nm, 460 nm, 465 nm, 470 nm, 475 nm, 480 nm, etc.

As illustrated in FIG. 3A, the blue light L1 emitted by the second light-emitting layer 332, the third light-emitting layer 333, and the fourth light-emitting layer 334 forms a first standing wave W1 in the resonant cavity of the light-emitting device 310, and the green light L2 emitted by the first light-emitting layer 331 forms a second standing wave W2 in the resonant cavity of the light-emitting device 310. Taking the surface of the first electrode 121 facing the first light-emitting layer 331 as a reference plane, the first light-emitting layer 331 is at the second antinode W22 of the second standing wave W2, the second light-emitting layer 332 is at the third antinode W13 of the first standing wave W1, the third light-emitting layer 333 is at the fourth antinode W14 of the first standing wave W1, and the fourth light-emitting layer 334 is at the fifth antinode W15 of the first standing wave W1. Since the light-emitting layers 331, 332, 333, and 334 are all at the antinodes of the corresponding standing waves, the blue light L1 emitted by the blue light-emitting layers 332, 333, and 334 can produce constructive interference to enhance the light intensity of the blue light L1, and the green light L2 emitted by the green light-emitting layer 331 can produce constructive interference to enhance the light intensity of the green light L2.

The first distance X2 between the surface of the first electrode 121 facing the second electrode 122 and the surface of the second electrode 122 facing the first electrode 121 is 500-550 nm, such as 500 nm, 510 nm, 520 nm, 530 nm, 540 nm, 550 nm, etc. In an example, the first distance X2 is equal to 5 times the distance between two adjacent antinodes of the first standing wave W1 (i.e. $T_B$), or 4 times the distance between two adjacent antinodes of the second standing wave W2 (i.e. $T_G$). The first distance X2 can make the difference between the optimal resonant cavity positions of the blue light L1 and the green light L2 very small or even negligible, so that the light-emitting efficiency of the light-emitting device 310 can be maximized.

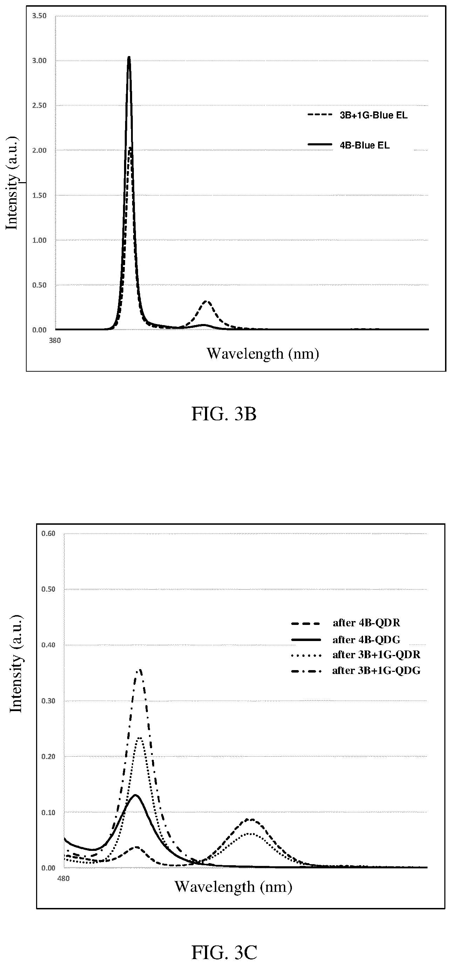

FIG. 3B illustrates a comparison of spectrum diagrams of the emitted light before being converted by the wavelength conversion layer, wherein the curve "4B-Blue EL" represents the spectral diagram of the emitted light of a conventional light-emitting device comprising four blue light-emitting layers, and the curve "3B+1G-Blue EL" represents the spectral diagram of the emitted light of the light-emitting device 310 illustrated in FIG. 3A. It can be seen from FIG. 3B that the curve 3B+1G-Blue EL has two peaks, the peak with higher intensity has a shorter wavelength, which is the peak wavelength corresponding to the blue light L1; the peak with lower intensity has a longer wavelength, which is the peak wavelength corresponding to the green light L2. Moreover, the curve 3B+1G-Blue EL only shows one peak of blue light, which indicates that the blue light respectively emitted by the second light-emitting layer 332, the third light-emitting layer 333 and the fourth light-emitting layer 334 has substantially the same peak wavelength.

FIG. 3C illustrates a comparison of spectrum diagrams of the emitted light after being converted by the wavelength conversion layer, wherein the curve "after 4B-QDR" represents a spectrum diagram of the light that is emitted by a conventional light-emitting device comprising four blue light-emitting layers and converted by red quantum dots, the curve "after 4B-QDG" represents a spectrum diagram of the light that is emitted by a conventional light-emitting device comprising four blue light-emitting layers and converted by green quantum dots, the curve "after 3B+1G-QDR" represents a spectrum diagram of the light that is emitted by the light-emitting device 310 illustrated in FIG. 3A and converted by red quantum dots, and the curve "after 3B+1G-QDG" represents a spectrum diagram of the light that is emitted by the light-emitting device 310 illustrated in FIG. 3A and converted by green quantum dots. Comparing the curves "after 4B-QDR" and "after 3B+1G-QDR", it can be seen that, compared with the conventional light-emitting device comprising four blue light-emitting layers, the intensity of the emitted red light is improved after the light emitted by the light-emitting device 310 illustrated in FIG. 3A is converted by red quantum dots. Comparing the curves "after 4B-QDG" and "after 3B+1G-QDG", it can be seen that, compared with the conventional light-emitting device comprising four blue light-emitting layers, the intensity of the emitted green light is significantly improved after the light emitted by the light-emitting device 310 illustrated in FIG. 3A is converted by green quantum dots. Moreover, the significance of the increase in green light intensity is greater than that of red light intensity.

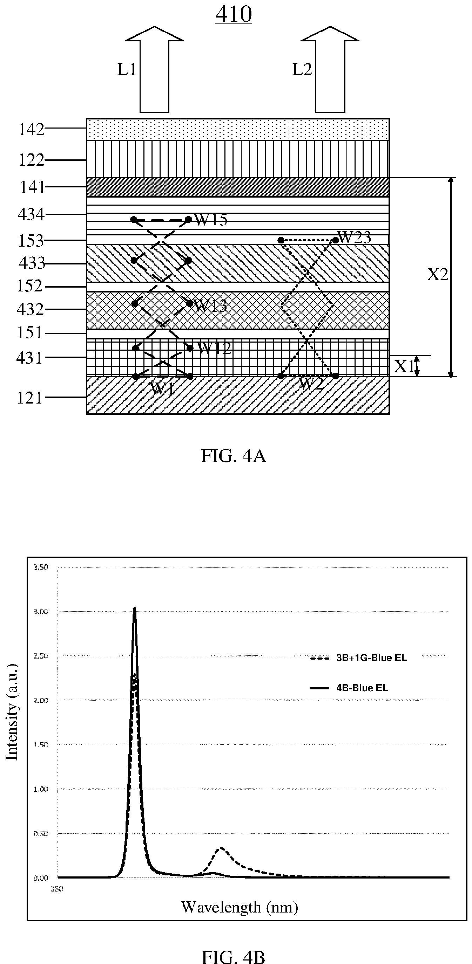

FIG. 4A illustrates an arrangement of a light-emitting device 410 which is a variant of the light-emitting device 210. The light-emitting device 410 illustrated in FIG. 4A has substantially the same configuration as the light-emitting device 210 illustrated in FIG. 2A, and thus the same reference numerals are used to designate the same components. Therefore, for the specific structures and functions of components with the same reference numerals in FIG. 4A as those in FIG. 2A, reference may be made to the description of FIG. 2A, and details will not be repeated here. For the sake of brevity, only the differences between the light-emitting device 410 and the light-emitting device 210 are introduced below.

As illustrated in FIG. 4A, the light-emitting device 410 comprises: a first electrode 121; a first light-emitting layer 431 on the first electrode 121; a second light-emitting layer 432 on the side of the first light-emitting layer 431 away from the first electrode 121; a third light-emitting layer 433 on the side of the second light-emitting layer 432 away from the first electrode 121; a fourth light-emitting layer 434 on the side of the third light-emitting layer 433 away from the first electrode 121; and a second electrode 122 on the side of the fourth light-emitting layer 434 away from the first electrode 121. The first light-emitting layer 431, the second light-emitting layer 432, and the fourth light-emitting layer 434 emit blue light L1, and the third light-emitting layer 433 emits green light L2. The blue light emitted by the first light-emitting layer 431, the second light-emitting layer 432, and the fourth light-emitting layer 434 has substantially the same peak wavelength, and the ratio of the peak wavelength of the blue light to the peak wavelength of the green light emitted by the third light-emitting layer 433 is in the range of 0.82-0.84. By making the ratio of the peak wavelength of the blue light to the peak wavelength of the green light within the range of 0.82-0.84, the position of the resonant cavity of the blue light can be closer to the position of the resonant cavity of the green light, so that the light-emitting efficiency of the light-emitting device 410 can be maximized.

The second distance X1 between the light-emitting center of the first light-emitting layer 431 and the surface of the first electrode 121 facing the first light-emitting layer 431 is greater than or equal to 100 nm. In the example of FIG. 4A, the second distance X1 is 115-135 nm, such as 115 nm, 120 nm, 125 nm, 130 nm, 135 nm, and so on. In an example, the second distance X1 is equal to 125 nm. The distance between the light-emitting center of the second light-emitting layer 432 and the surface of the first electrode 121 facing the first light-emitting layer 431 is 225-255 nm, such as 225 nm, 230 nm, 235 nm, 240 nm, 245 nm, 250 nm, 255 nm, etc. The distance between the light-emitting center of the third light-emitting layer 433 and the surface of the first electrode 121 facing the first light-emitting layer 431 is 340-370 nm, such as 340 nm, 345 nm, 350 nm, 355 nm, 360 nm, 365 nm, 370 nm, etc. The distance between the light-emitting center of the fourth light-emitting layer 434 and the surface of the first electrode 121 facing the first light-emitting 431 is 450-480 nm, such as 450 nm, 455 nm, 460 nm, 465 nm, 470 nm, 475 nm, 480 nm, etc.

As illustrated in FIG. 4A, the blue light L1 emitted by the first light-emitting layer 431, the second light-emitting layer 432, and the fourth light-emitting layer 434 forms a first standing wave W1 in the resonant cavity of the light-emitting device 410, and the green light L2 emitted by the third light-emitting layer 433 forms a second standing wave W2 in the resonant cavity of the light-emitting device 410. Taking the surface of the first electrode 121 facing the first light-emitting layer 431 as a reference plane, the first light-emitting layer 431 is at the second antinode W12 of the first standing wave W1, the second light-emitting layer 432 is at the third antinode W13 of the first standing wave W1, the fourth light-emitting layer 434 is at the fifth antinode W15 of the first standing wave W1, and the third light-emitting layer 433 is near the third antinode W23 of the second standing wave W2. In an example, the distance between the third light-emitting layer 433 and the third antinode W23 of the second standing wave W2 is 10-30 nm, such as 10 nm, 15 nm, 20 nm, 25 nm, 30 nm, and so on. It should be noted that the meaning of the phrase "the distance between the third light-emitting layer 433 and the third antinode W23 of the second standing wave W2 is 10-30 nm" comprises: the third light-emitting layer 433 is on a side of the third antinode W23 of the second standing wave W2 close to the first electrode 121 and is spaced 10-30 nm from the third antinode W23, that is, the position of the third light-emitting layer 433 does not reach the position of the third antinode W23 of the second standing wave W2, as illustrated in FIG. 4A; or, the third light-emitting layer 433 is on a side of the third antinode W23 of the second standing wave W2 away from the first electrode 121 and is spaced 10-30 nm from the third antinode W23, that is, the position of the third light-emitting layer 43 exceeds the position of the third antinode W23 of the second standing wave W2. Since the light-emitting layers 431, 432 and 434 are at corresponding antinodes of the standing wave W1, the blue light L1 emitted by the light-emitting layers 431, 432 and 434 can produce constructive interference to enhance the light-emitting intensity of the blue light L1.

The first distance X2 between the surface of the first electrode 121 facing the second electrode 122 and the surface of the second electrode 122 facing the first electrode 121 is 500-550 nm, such as 500 nm, 510 nm, 520 nm, 530 nm, 540 nm, 550 nm, etc. In an example, the first distance X2 is equal to 5 times the distance between two adjacent antinodes of the first standing wave W1 (i.e. $T_B$), or 4 times the distance between two adjacent antinodes of the second standing wave W2 (i.e. $T_G$). The first distance X2 can make the difference between the optimal resonant cavity positions of the blue light L1 and the green light L2 very small or even negligible, so that the light-emitting efficiency of the light-emitting device 410 can be maximized.

FIG. 4B illustrates a comparison of spectrum diagrams of the emitted light before being converted by the wavelength conversion layer, wherein the curve "4B-Blue EL" represents the spectral diagram of the emitted light of a conventional light-emitting device comprising four blue light-emitting layers, and the curve "3B+1G-Blue EL" represents the spectral diagram of the emitted light of the light-emitting device 410 illustrated in FIG. 4A. It can be seen from FIG. 4B that the curve 3B+1G-Blue EL has two peaks, the peak with higher intensity has a shorter wavelength, which is the peak wavelength corresponding to the blue light L1; the peak with lower intensity has a longer wavelength, which is the peak wavelength corresponding to the green light L2. Moreover, the curve 3B+1G-Blue EL only shows one peak of blue light, which indicates that the blue light respectively emitted by the first light-emitting layer 431, the second light-emitting layer 432 and the fourth light-emitting layer 434 has substantially the same peak wavelength.

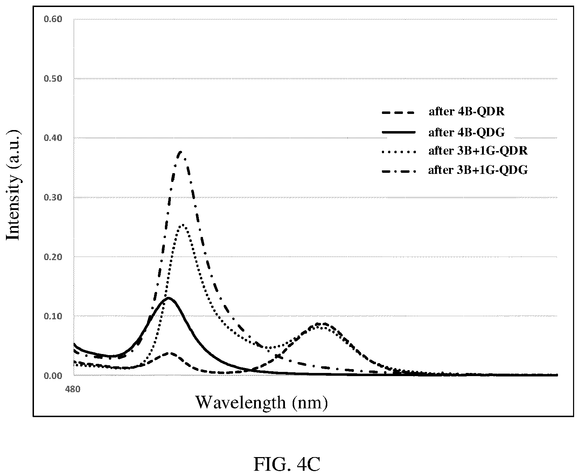

FIG. 4C illustrates a comparison of spectrum diagrams of the emitted light after being converted by the wavelength conversion layer, wherein the curve "after 4B-QDR" represents a spectrum diagram of the light that is emitted by a conventional light-emitting device comprising four blue light-emitting layers and converted by red quantum dots, the curve "after 4B-QDG" represents a spectrum diagram of the light that is emitted by a conventional light-emitting device comprising four blue light-emitting layers and converted by green quantum dots, the curve "after 3B+1G-QDR" represents a spectrum diagram of the light that is emitted by the light-emitting device 410 illustrated in FIG. 4A and converted by red quantum dots, and the curve "after 3B+1G-QDG" represents a spectrum diagram of the light that is emitted by the light-emitting device 410 illustrated in FIG. 4A and converted by green quantum dots. Comparing the curves "after 4B-QDR" and "after 3B+1G-QDR", it can be seen that, compared with the conventional light-emitting device comprising four blue light-emitting layers, the intensity of the emitted red light is improved after the light emitted by the light-emitting device 410 illustrated in FIG. 4A is converted by red quantum dots. Comparing the curves "after 4B-QDG" and "after 3B+1G-QDG", it can be seen that, compared with the conventional light-emitting device comprising four blue light-emitting layers, the intensity of the emitted green light is significantly improved after the light emitted by the light-emitting device 410 illustrated in FIG. 4A is converted by green quantum dots. Moreover, the significance of the increase in green light intensity is greater than that of red light intensity.

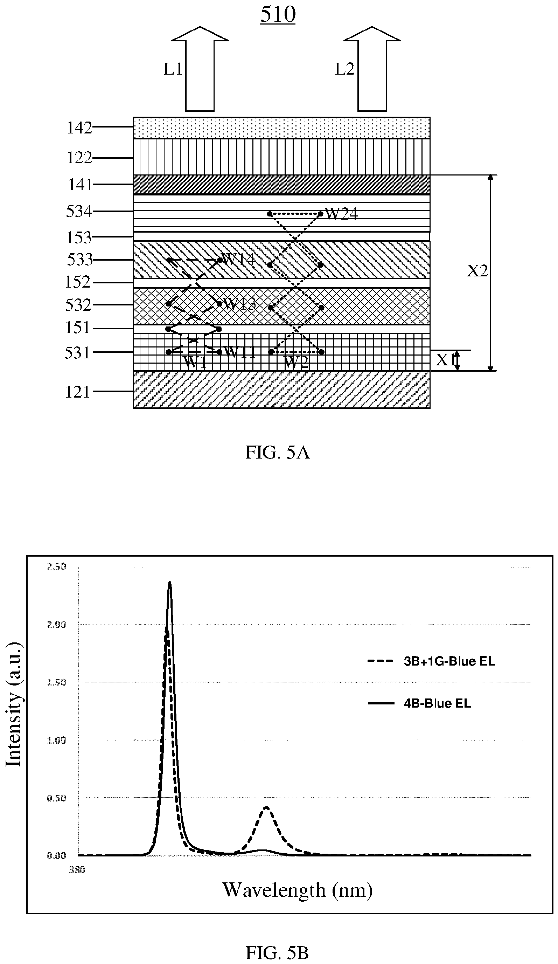

FIG. 5A illustrates an arrangement of a light-emitting device 510 which is a variant of the light-emitting device 210. The light-emitting device 510 illustrated in FIG. 5A has substantially the same configuration as the light-emitting device 210 illustrated in FIG. 2A, and thus the same reference numerals are used to designate the same components. Therefore, for the specific structures and functions of components with the same reference numerals in FIG. 5A as those in FIG. 2A, reference may be made to the description of FIG. 2A, and details will not be repeated here. For the sake of brevity, only the differences between the light-emitting device 510 and the light-emitting device 210 are introduced below.

As illustrated in FIG. 5A, the light-emitting device 510 comprises: a first electrode 121; a first light-emitting layer 531 on the first electrode 121; a second light-emitting layer 532 on the side of the first light-emitting layer 531 away from the first electrode 121; a third light-emitting layer 533 on the side of the second light-emitting layer 532 away from the first electrode 121; a fourth light-emitting layer 534 on the side of the third light-emitting layer 533 away from the first electrode 121; and a second electrode 122 on the side of the fourth light-emitting layer 534 away from the first electrode 121. The first light-emitting layer 531, the second light-emitting layer 532 and the third light-emitting layer 533 emit blue light L1, and the fourth light-emitting layer 534 emits green light L2. The blue light emitted by the first light-emitting layer 531, the second light-emitting layer 532 and the third light-emitting layer 533 has substantially the same peak wavelength, and the ratio of the peak wavelength of the blue light to the peak wavelength of the green light emitted by the fourth light-emitting layer 534 is in the range of 0.82-0.84. By making the ratio of the peak wavelength of the blue light to the peak wavelength of the green light within the range of 0.82-0.84, the position of the resonant cavity of the blue light can be closer to the position of the resonant cavity of the green light, so that the light-emitting efficiency of the light-emitting device 510 can be maximized.

The second distance X1 between the light-emitting center of the first light-emitting layer 531 and the surface of the first electrode 121 facing the first light-emitting layer 531 is less than 100 nm. In the example of FIG. 5A, the second distance X1 is 20-30 nm, such as 20 nm, 25 nm, 30 nm, and so on. In an example, the second distance X1 is equal to 25 nm. The distance between the light-emitting center of the second light-emitting layer 532 and the surface of the first electrode 121 facing the first light-emitting layer 531 is 225-255 nm, such as 225 nm, 230 nm, 235 nm, 240 nm, 245 nm, 250 nm, 255 nm, etc. The distance between the light-emitting center of the third light-emitting layer 533 and the surface of the first electrode 121 facing the first light-emitting layer 531 is 340-370 nm, such as 340 nm, 345 nm, 350 nm, 355 nm, 360 nm, 365 nm, 370 nm, etc. The distance between the light-emitting center of the fourth light-emitting layer 534 and the surface of the first electrode 121 facing the first light-emitting layer 531 is 450-480 nm, such as 450 nm, 455 nm, 460 nm, 465 nm, 470 nm, 475 nm, 480 nm, etc.

As illustrated in FIG. 5A, the blue light L1 emitted by the first light-emitting layer 531, the second light-emitting layer 532, and the third light-emitting layer 534 forms a first standing wave W1 in the resonant cavity of the light-emitting device 510, and the green light L2 emitted by the fourth light-emitting layer 534 forms a second standing wave W2 in the resonant cavity of the light-emitting device 510. Taking the surface of the first electrode 121 facing the first light-emitting layer 531 as a reference plane, the first light-emitting layer 531 is at the first antinode W11 of the first standing wave W1, the second light-emitting layer 532 is at the third antinode W13 of the first standing wave W1, the third light-emitting layer 533 is at the fourth antinode W14 of the first standing wave W1, and the fourth light-emitting layer 534 is at the fourth antinode W24 of the second standing wave W2. Since the light-emitting layers 531, 532, 533, and 534 are all at the antinodes of the corresponding standing waves, the blue light L1 emitted by the blue light-emitting layers 531, 532, and 533 can produce constructive interference to enhance the light intensity of the blue light L1, and the green light L2 emitted by the green light-emitting layer 534 can produce constructive interference to enhance the light intensity of the green light L2.

The first distance X2 between the surface of the first electrode 121 facing the second electrode 122 and the surface of the second electrode 122 facing the first electrode 121 is 500-550 nm. In an example, the first distance X2 is equal to 5 times the distance between two adjacent antinodes of the first standing wave W1 (i.e. $T_B$), or 4 times the distance between two adjacent antinodes of the second standing wave W2 (i.e. $T_G$). The first distance X2 can make the difference between the optimal resonant cavity positions of the blue light L1 and the green light L2 very small or even negligible, so that the light-emitting efficiency of the light-emitting device 510 can be maximized.

FIG. 5B illustrates a comparison of spectrum diagrams of the emitted light before being converted by the wavelength conversion layer, wherein the curve "4B-Blue EL" represents the spectral diagram of the emitted light of a conventional light-emitting device comprising four blue light-emitting layers, and the curve "3B+1G-Blue EL" represents the spectral diagram of the emitted light of the light-emitting device 510 illustrated in FIG. 5A. It can be seen from FIG. 5B that the curve 3B+1G-Blue EL has two peaks, the peak with higher intensity has a shorter wavelength, which is the peak wavelength corresponding to the blue light L1; the peak with lower intensity has a longer wavelength, which is the peak wavelength corresponding to the green light L2. Moreover, the curve 3B+1G-Blue EL only shows one peak of blue light, which indicates that the blue light respectively emitted by the first light-emitting layer 531, the second light-emitting layer 532 and the third light-emitting layer 533 has substantially the same peak wavelength.

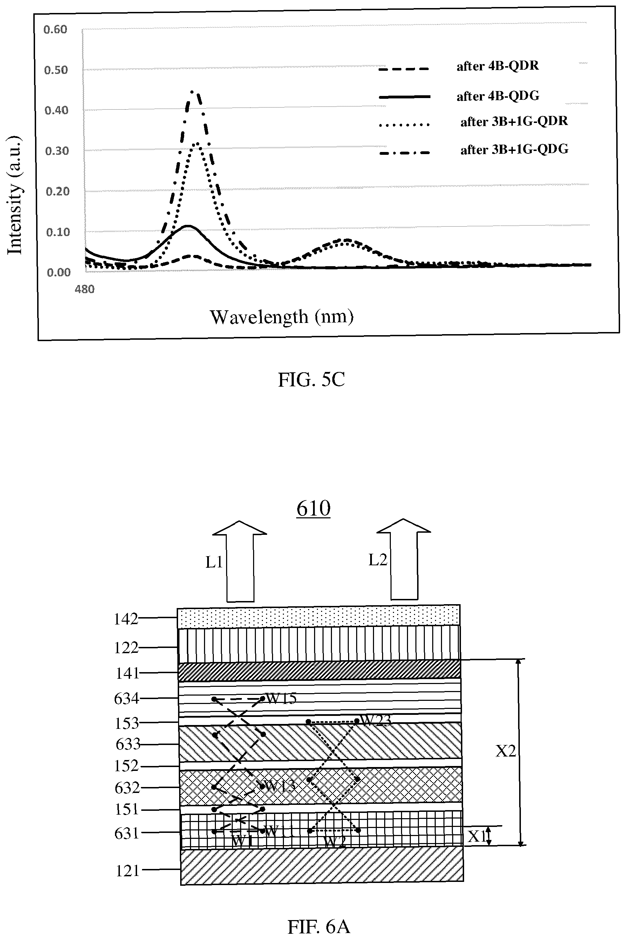

FIG. 5C illustrates a comparison of spectrum diagrams of the emitted light after being converted by the wavelength conversion layer, wherein the curve "after 4B-QDR" represents a spectrum diagram of the light that is emitted by a conventional light-emitting device comprising four blue light-emitting layers and converted by red quantum dots, the curve "after 4B-QDG" represents a spectrum diagram of the light that is emitted by a conventional light-emitting device comprising four blue light-emitting layers and converted by green quantum dots, the curve "after 3B+1G-QDR" represents a spectrum diagram of the light that is emitted by the light-emitting device 510 illustrated in FIG. 5A and converted by red quantum dots, and the curve "after 3B+1G-QDG" represents a spectrum diagram of the light that is emitted by the light-emitting device 510 illustrated in FIG. 5A and converted by green quantum dots. Comparing the curves "after 4B-QDR" and "after 3B+1G-QDR", it can be seen that, compared with the conventional light-emitting device comprising four blue light-emitting layers, the intensity of the emitted red light is improved after the light emitted by the light-emitting device 510 illustrated in FIG. 5A is converted by red quantum dots. Comparing the curves "after 4B-QDG" and "after 3B+1G-QDG", it can be seen that, compared with the conventional light-emitting device comprising four blue light-emitting layers, the intensity of the emitted green light is significantly improved after the light emitted by the light-emitting device 510 illustrated in FIG. 5A is converted by green quantum dots. Moreover, the significance of the increase in green light intensity is greater than that of red light intensity.

FIG. 6A illustrates an arrangement of a light-emitting device 610 which is a variant of the light-emitting device 210. The light-emitting device 610 illustrated in FIG. 6A has substantially the same configuration as the light-emitting device 210 illustrated in FIG. 2A, and thus the same reference numerals are used to designate the same components. Therefore, for the specific structures and functions of components with the same reference numerals in FIG. 6A as those in FIG. 2A, reference may be made to the description of FIG. 2A, and details will not be repeated here. For the sake of brevity, only the differences between the light-emitting device 610 and the light-emitting device 210 are introduced below.

As illustrated in FIG. 6A, the light-emitting device 610 comprises: a first electrode 121; a first light-emitting layer 631 on the first electrode 121; a second light-emitting layer 632 on the side of the first light-emitting layer 631 away from the first electrode 121; a third light-emitting layer 633 on the side of the second light-emitting layer 632 away from the first electrode 121; a fourth light-emitting layer 634 on the side of the third light-emitting layer 633 away from the first electrode 121; and a second electrode 122 on the side of the fourth light-emitting layer 634 away from the first electrode 121. The first light-emitting layer 631, the second light-emitting layer 632, and the fourth light-emitting layer 634 emit blue light L1, and the third light-emitting layer 633 emits green light L2. The blue light emitted by the first light-emitting layer 631, the second light-emitting layer 632, and the fourth light-emitting layer 634 has substantially the same peak wavelength, and the ratio of the peak wavelength of the blue light to the peak wavelength of the green light emitted by the third light-emitting layer 633 is in the range of 0.82-0.84. By making the ratio of the peak wavelength of the blue light to the peak wavelength of the green light within the range of 0.82-0.84, the position of the resonant cavity of the blue light can be closer to the position of the resonant cavity of the green light, so that the light-emitting efficiency of the light-emitting device 610 can be maximized.

The second distance X1 between the light-emitting center of the first light-emitting layer 631 and the surface of the first electrode 121 facing the first light-emitting layer 631 is less than 100 nm. In the example of FIG. 6A, the second distance X1 is 20-30 nm, such as 20 nm, 25 nm, 30 nm, and so on. In an example, the second distance X1 is equal to 25 nm. The distance between the light-emitting center of the second light-emitting layer 632 and the surface of the first electrode 121 facing the first light-emitting layer 631 is 225-255 nm, such as 225 nm, 230 nm, 235 nm, 240 nm, 245 nm, 250 nm, 255 nm, etc. The distance between the light-emitting center of the third light-emitting layer 633 and the surface of the first electrode 121 facing the first light-emitting layer 631 is 340-370 nm, such as 340 nm, 345 nm, 350 nm, 355 nm, 360 nm, 365 nm, 370 nm, etc. The distance between the light-emitting center of the fourth light-emitting layer 634 and the surface of the first electrode 121 facing the first light-emitting layer 631 is 450-480 nm, such as 450 nm, 455 nm, 460 nm, 465 nm, 470 nm, 475 nm, 480 nm, etc.

As illustrated in FIG. 6A, the blue light L1 emitted by the first light-emitting layer 631, the second light-emitting layer 632, and the fourth light-emitting layer 634 forms a first standing wave W1 in the resonant cavity of the light-emitting device 610, and the green light L2 emitted by the third light-emitting layer 633 forms a second standing wave W2 in the resonant cavity of the light-emitting device 610. Taking the surface of the first electrode 121 facing the first light-emitting layer 631 as a reference plane, the first light-emitting layer 631 is at the first antinode W11 of the first standing wave W1, the second light-emitting layer 632 is at the third antinode W13 of the first standing wave W1, the fourth light-emitting layer 634 is at the fifth antinode W15 of the first standing wave W1, and the third light-emitting layer 633 is near the third antinode W23 of the second standing wave W2. In an example, the distance between the third light-emitting layer 633 and the third antinode W23 of the second standing wave W2 is 10-30 nm, such as 10 nm, 15 nm, 20 nm, 25 nm, 30 nm, and so on. It should be noted that the meaning of the phrase "the distance between the third light-emitting layer 633 and the third antinode W23 of the second standing wave W2 is 10-30 nm" comprises: the third light-emitting layer 633 is on the side of the third antinode W23 of the second standing wave W2 close to the first electrode 121 and spaced 10-30 nm from the third antinode W23, that is, the position of the third light-emitting layer 633 does not reach the position of the third antinode W23 of the second standing wave W2, as illustrated in FIG. 6A; or, the third light-emitting layer 633 is on the side of the third antinode W23 of the second standing wave W2 away from the first electrode 121 and spaced 10-30 nm from the third antinode W23, that is, the position of the third light-emitting layer 633 exceeds the position of the third antinode W23 of the second standing wave W2. Since the light-emitting layers 631, 632 and 634 are all at corresponding antinodes of the standing wave W1, the blue light L1 emitted by the light-emitting layers 631, 632 and 634 can produce constructive interference to enhance the light intensity of the blue light L1.

The first distance X2 between the surface of the first electrode 121 facing the second electrode 122 and the surface of the second electrode 122 facing the first electrode 121 is 500-550 nm. In an example, the first distance X2 is equal to 5 times the distance between two adjacent antinodes of the first standing wave W1 (i.e. $T_B$), or 4 times the distance between two adjacent antinodes of the second standing wave W2 (i.e. $T_G$). The first distance X2 can make the difference between the optimal resonant cavity positions of the blue light L1 and the green light L2 very small or even negligible, so that the light-emitting efficiency of the light-emitting device 610 can be maximized.

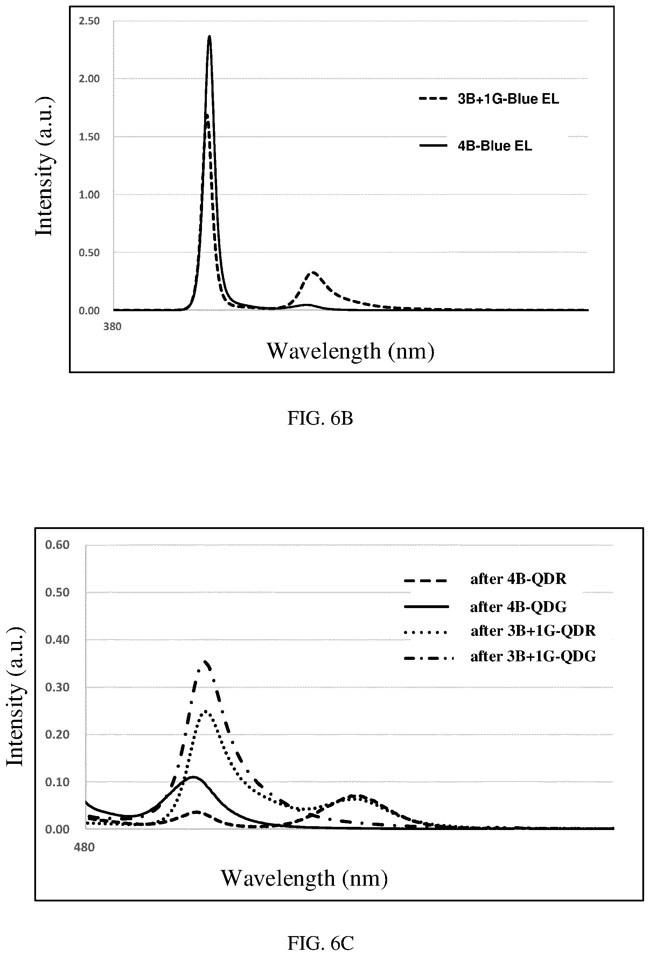

FIG. 6B illustrates a comparison of spectrum diagrams of the emitted light before being converted by the wavelength conversion layer, wherein the curve "4B-Blue EL" represents the spectral diagram of the emitted light of a conventional light-emitting device comprising four blue light-emitting layers, and the curve "3B+1G-Blue EL" represents the spectral diagram of the emitted light of the light-emitting device 610 illustrated in FIG. 6A. It can be seen from FIG. 6B that the curve 3B+1G-Blue EL has two peaks, the peak with higher intensity has a shorter wavelength, which is the peak wavelength corresponding to the blue light L1; the peak with lower intensity has a longer wavelength, which is the peak wavelength corresponding to the green light L2. Moreover, the curve 3B+1G-Blue EL only shows one peak of blue light, which indicates that the blue light respectively emitted by the first light-emitting layer 631, the second light-emitting layer 632 and the fourth light-emitting layer 634 has substantially the same peak wavelength.

FIG. 6C illustrates a comparison of spectrum diagrams of the emitted light after being converted by the wavelength conversion layer, wherein the curve "after 4B-QDR" represents a spectrum diagram of the light that is emitted by a conventional light-emitting device comprising four blue light-emitting layers and converted by red quantum dots, the curve "after 4B-QDG" represents a spectrum diagram of the light that is emitted by a conventional light-emitting device comprising four blue light-emitting layers and converted by green quantum dots, the curve "after 3B+1G-QDR" represents a spectrum diagram of the light that is emitted by the light-emitting device 610 illustrated in FIG. 6A and converted by red quantum dots, and the curve "after 3B+1G-QDG" represents a spectrum diagram of the light that is emitted by the light-emitting device 610 illustrated in FIG. 6A and converted by green quantum dots. Comparing the curves "after 4B-QDR" and "after 3B+1G-QDR", it can be seen that, compared with the conventional light-emitting device comprising four blue light-emitting layers, the intensity of the emitted red light is improved after the light emitted by the light-emitting device 610 illustrated in FIG. 6A is converted by red quantum dots. Comparing the curves "after 4B-QDG" and "after 3B+1G-QDG", it can be seen that, compared with the conventional light-emitting device comprising four blue light-emitting layers, the intensity of the emitted green light is significantly improved after the light emitted by the light-emitting device 610 illustrated in FIG. 6A is converted by green quantum dots.

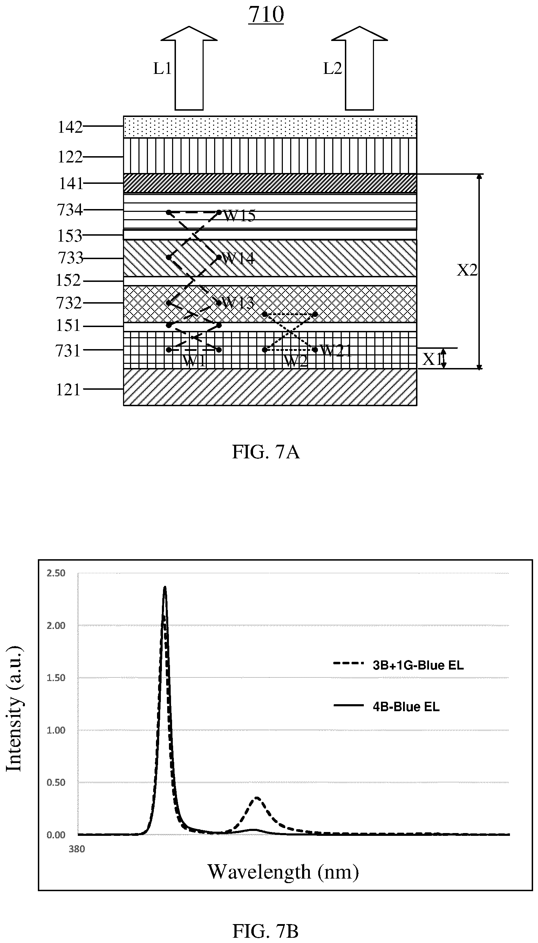

FIG. 7A illustrates an arrangement of a light-emitting device 710 which is a variant of the light-emitting device 210. The light-emitting device 710 illustrated in FIG. 7A has substantially the same configuration as the light-emitting device 210 illustrated in FIG. 2A, and thus the same reference numerals are used to designate the same components.

Therefore, for the specific structures and functions of components with the same reference numerals in FIG. 7A as those in FIG. 2A, reference may be made to the description of FIG. 2A, and details will not be repeated here. For the sake of brevity, only the differences between the light-emitting device 710 and the light-emitting device 210 are introduced below.

As illustrated in FIG. 7A, the light-emitting device 710 comprises: a first electrode 121; a first light-emitting layer 731 on the first electrode 121; a second light-emitting layer 732 on the side of the first light-emitting layer 731 away from the first electrode 121; a third light-emitting layer 733 on the side of the second light-emitting layer 732 away from the first electrode 121; a fourth light-emitting layer 734 on the side of the third light-emitting layer 733 away from the first electrode 121; and a second electrode 122 on the side of the fourth light-emitting layer 734 away from the first electrode 121. The second light-emitting layer 732, the third light-emitting layer 733 and the fourth light-emitting layer 734 emit blue light L1, and the first light-emitting layer 731 emits green light L2. The blue light emitted by the second light-emitting layer 732, the third light-emitting layer 733 and the fourth light-emitting layer 734 has substantially the same peak wavelength, and the ratio of the peak wavelength of the blue light to the peak wavelength of the green light emitted by the first light-emitting layer 731 is in the range of 0.82-0.84. By making the ratio of the peak wavelength of the blue light to the peak wavelength of the green light within the range of 0.82-0.84, the position of the resonant cavity of the blue light can be closer to the position of the resonant cavity of the green light, so that the light-emitting efficiency of the light-emitting device 710 can be maximized.

The second distance X1 between the light-emitting center of the first light-emitting layer 731 and the surface of the first electrode 121 facing the first light-emitting layer 731 is less than 100 nm. In the example of FIG. 7A, the second distance X1 is 30-40 nm, such as 30 nm, 35 nm, 40 nm, etc. In an example, the second distance X1 is equal to 35 nm. The distance between the light-emitting center of the second light-emitting layer 732 and the surface of the first electrode 121 facing the first light-emitting layer 731 is 225-255 nm, such as 225 nm, 230 nm, 235 nm, 240 nm, 245 nm, 250 nm, 255 nm, etc. The distance between the light-emitting center of the third light-emitting layer 733 and the surface of the first electrode 121 facing the first light-emitting layer 731 is 340-370 nm, such as 340 nm, 345 nm, 350 nm, 355 nm, 360 nm, 365 nm, 370 nm, etc. The distance between the light-emitting center of the fourth light-emitting layer 734 and the surface of the first electrode 121 facing the first light-emitting layer 731 is 450-480 nm, such as 450 nm, 455 nm, 460 nm, 465 nm, 470 nm, 475 nm, 480 nm, etc.

As illustrated in FIG. 7A, the blue light L1 emitted by the second light-emitting layer 732, the third light-emitting layer 733 and the fourth light-emitting layer 734 forms a first standing wave W1 in the resonant cavity of the light-emitting device 710, the green light L2 emitted by the first light-emitting layer 731 forms a second standing wave W2 in the resonant cavity of the light-emitting device 710. Taking the surface of the first electrode 121 facing the first light-emitting layer 731 as a reference plane, the first light-emitting layer 731 is at the first antinode W21 of the second standing wave W2, the second light-emitting layer 732 is at the third antinode W13 of the first standing wave W1, the third light-emitting layer 733 is at the fourth antinode W14 of the first standing wave W1, and the fourth light-emitting layer 734 is at the fifth antinode W15 of the first standing wave W1. Since the light-emitting layers 731, 732, 733, and 734 are all at the antinodes of the corresponding standing waves, the blue light L1 emitted by the blue light-emitting layers 732, 733, and 734 can produce constructive interference to enhance the light intensity of the blue light L1, and the green light L2 emitted by the green light-emitting layer 731 can produce constructive interference to enhance the light intensity of the green light L2.

The first distance X2 between the surface of the first electrode 121 facing the second electrode 122 and the surface of the second electrode 122 facing the first electrode 121 is 500-550 nm. In an example, the first distance X2 is equal to 5 times the distance between two adjacent antinodes of the first standing wave W1 (i.e. $T_B$), or 4 times the distance between two adjacent antinodes of the second standing wave W2 (i.e. $T_G$). The first distance X2 can make the difference between the optimal resonant cavity positions of the blue light L1 and the green light L2 very small or even negligible, so that the light-emitting efficiency of the light-emitting device 710 can be maximized.

FIG. 7B illustrates a comparison of spectrum diagrams of the emitted light before being converted by the wavelength conversion layer, wherein the curve "4B-Blue EL" represents the spectral diagram of the emitted light of a conventional light-emitting device comprising four blue light-emitting layers, and the curve "3B+1G-Blue EL" represents the spectral diagram of the emitted light of the light-emitting device 710 illustrated in FIG. 7A. It can be seen from FIG. 7B that the curve 3B+1G-Blue EL has two peaks, the peak with higher intensity has a shorter wavelength, which is the peak wavelength corresponding to the blue light L1; the peak with lower intensity has a longer wavelength, which is the peak wavelength corresponding to the green light L2. Moreover, the curve 3B+1G-Blue EL only shows one peak of blue light, which indicates that the blue light respectively emitted by the second light-emitting layer 732, the third light-emitting layer 733 and the fourth light-emitting layer 734 has substantially the same peak wavelength.

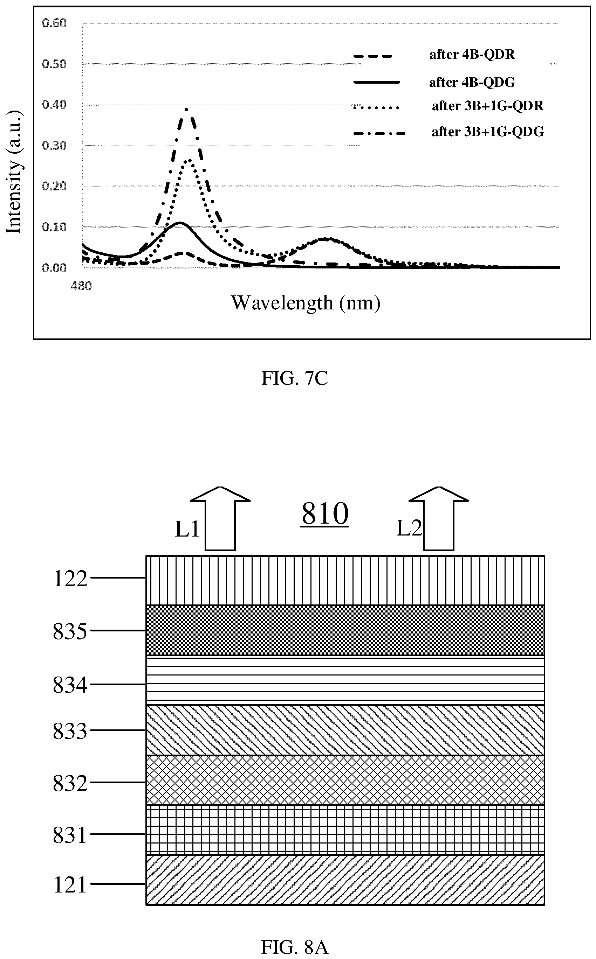

FIG. 7C illustrates a comparison of spectrum diagrams of the emitted light after being converted by the wavelength conversion layer, wherein the curve "after 4B-QDR" represents a spectrum diagram of the light that is emitted by a conventional light-emitting device comprising four blue light-emitting layers and converted by red quantum dots, the curve "after 4B-QDG" represents a spectrum diagram of the light that is emitted by a conventional light-emitting device comprising four blue light-emitting layers and converted by green quantum dots, the curve "after 3B+1G-QDR" represents a spectrum diagram of the light that is emitted by the light-emitting device 710 illustrated in FIG. 7A and converted by red quantum dots, and the curve "after 3B+1G-QDG" represents a spectrum diagram of the light that is emitted by the light-emitting device 710 illustrated in FIG. 7A and converted by green quantum dots. Comparing the curves "after 4B-QDR" and "after 3B+1G-QDR", it can be seen that, compared with the conventional light-emitting device comprising four blue light-emitting layers, the intensity of the emitted red light is improved after the light emitted by the light-emitting device 710 illustrated in FIG. 7A is converted by red quantum dots. Comparing the curves "after 4B-QDG" and "after 3B+1G-QDG", it can be seen that, compared with the conventional light-emitting device comprising four blue light-emitting layers, the intensity of the emitted green light is significantly improved after the light emitted by the light-emitting device 710 illustrated in FIG. 7A is converted by green quantum dots.

All the above embodiments describe that each light-emitting device comprises four stacked light-emitting layers, wherein three light-emitting layers emit blue light, and one light-emitting layer emits green light. In an alternative embodiment, the light-emitting device may also comprise five light-emitting layers stacked in sequence. As illustrated in FIG. 8A, the light-emitting device 810 comprises: a first electrode 121; a first light-emitting layer 831 on the first electrode 121; a second light-emitting layer 832 on the side of the first light-emitting layer 831 away from the first electrode 121; a third light-emitting layer 833 on the side of the second light-emitting layer 832 away from the first electrode 121; a fourth light-emitting layer 834 on the side of the third light-emitting layer 833 away from the first electrode 121; a fifth light-emitting layer 835 on the side of the fourth light-emitting layer 834 away from the first electrode 121; and a second electrode 122 on the side of the fifth light-emitting layer 835 away from the first electrode 121. The first light-emitting layer 831, the second light-emitting layer 832, the third light-emitting layer 833, and the fourth light-emitting layer 834 can be arranged with reference to the light-emitting layer in any of the light-emitting devices 210, 310, 410, 510, 610, 710 described in the previous embodiments. The fifth light-emitting layer 835 may emit light of the first wavelength or light of the second wavelength, the light of the first wavelength may be blue light, and the light of the second wavelength may be green light. That is to say, at least three light-emitting layers among the first light-emitting layer 831, the second light-emitting layer 832, the third light-emitting layer 833, the fourth light-emitting layer 834, and the fifth light-emitting layer 835 emit blue light L1, and the remaining light-emitting layer of the first light-emitting layer 831, the second light-emitting layer 832, the third light-emitting layer 833, the fourth light-emitting layer 834 and the fifth light-emitting layer 835 except the at least three light-emitting layers emit green light L2. In some embodiments, any three light-emitting layers of the first light-emitting layer 831, the second light-emitting layer 832, the third light-emitting layer 833, the fourth light-emitting layer 834, and the fifth light-emitting layer 835 emit blue light L1, while the remaining two light-emitting layers emit green light L2. In an alternative embodiment, any four light-emitting layers of the first light-emitting layer 831, the second light-emitting layer 832, the third light-emitting layer 833, the fourth light-emitting layer 834, and the fifth light-emitting layer 835 emit blue light L1, while the remaining one light-emitting layer emits green light L2. The light-emitting layers emitting blue light among the first light-emitting layer 831, the second light-emitting layer 832, the third light-emitting layer 833, the fourth light-emitting layer 834 and the fifth light-emitting layer 835 may be at corresponding antinodes of the first standing wave W1, and the light-emitting layer emitting green light may be at a corresponding antinode of the second standing wave W2.

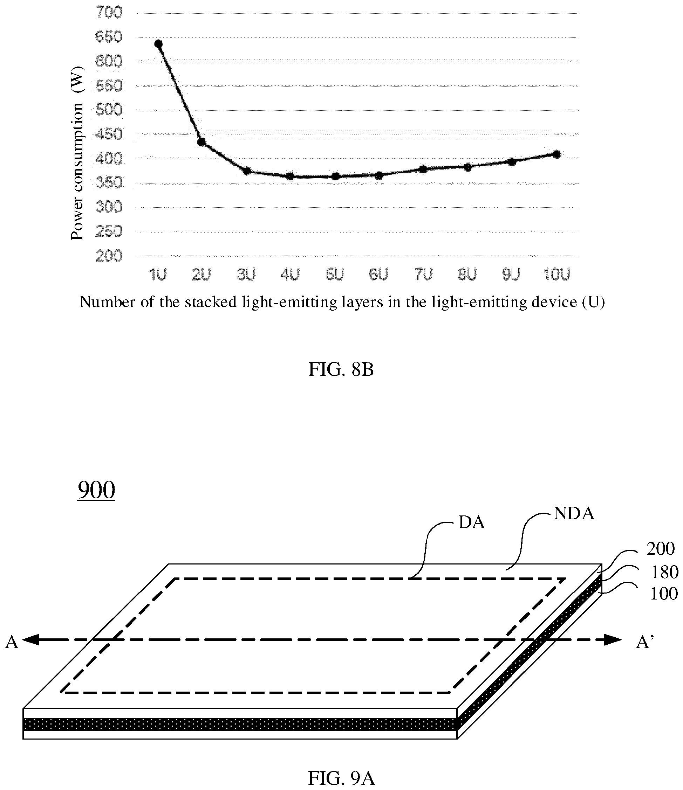

FIG. 8B illustrates a graph of the relationship between the power consumption of the light-emitting device and the number of stacked layers of the light-emitting layers in the light-emitting device, where the abscissa represents the number of stacked layers of the light-emitting layers (U), and the ordinate represents the power consumption of the light-emitting device (W). It can be seen from FIG. 8B that when the number of stacked layers of the light-emitting layers in the light-emitting device is 4 or 5 layers, the power consumption of the light-emitting device is the lowest.

In some embodiments, in the light-emitting device described above, the material of the light-emitting layer which is used to emit blue light L1 may be a fluorescent light-emitting material, and the material of the light-emitting layer which is used to emit green light L2 may be a phosphorescent light-emitting material.

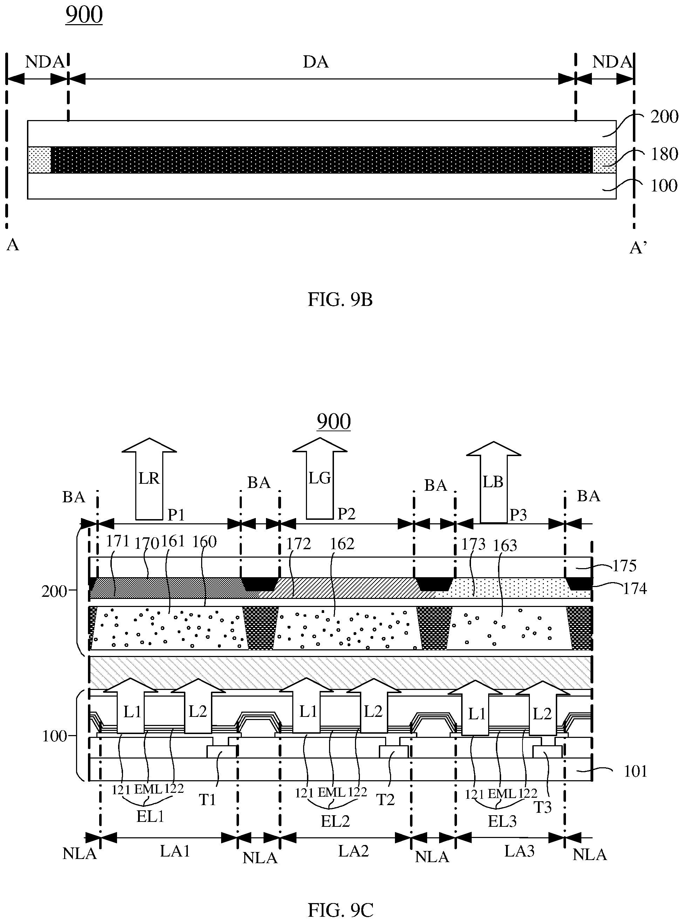

According to another aspect of the present disclosure, a display panel is provided, the display panel comprises the light-emitting substrate 100 described in any one of the previous embodiments, in this case, the light-emitting substrate 100 may be an array substrate. FIG. 9A illustrates a plan view of the display panel 900, FIG. 9B illustrates a cross-sectional view of the display panel 900 taken along the line AA' of FIG. 9A, and FIG. 9C illustrates a more detailed layout diagram of the display panel 900 illustrated in FIG. 9B.

Referring to FIGS. 9A-9C, the display panel 900 comprises the light-emitting substrate 100, a counter substrate 200 opposite to the light-emitting substrate 100, and a sealant 180 sealing the light-emitting substrate 100 and the counter substrate 200. The display panel 900 comprises a display region DA and a non-display region NDA surrounding the display region DA. The display panel 900 comprises a plurality of sub-pixels arranged in an array, and each sub-pixel is provided with a light-emitting device described in any one of the foregoing embodiments. For the sake of brevity, FIG. 9C only illustrates three adjacent sub-pixels, that is, the first sub-pixel P1, the second sub-pixel P2 and the third sub-pixel P3, other sub-pixels not illustrated are arranged in the same way as the sub-pixels P1, P2, P3. A light-emitting device EL1 is arranged in the first sub-pixel P1, a light-emitting device EL2 is arranged in the second sub-pixel P2, and a light-emitting device EL3 is arranged in the third sub-pixel P3. The light-emitting devices EL1, EL2, EL3 may be any one of the light-emitting devices 110, 210, 310, 410, 510, 610, 710, 810 described in the previous embodiments, for example, each light-emitting device comprises the first electrode 121, the second electrode 122, and four or five light-emitting layers EML between the first electrode 121 and the second electrode 122.

As illustrated in FIG. 9C, the light-emitting substrate 100 comprises a first base substrate 101 on which the light-emitting devices EL1, EL2, and EL3 are arranged. A switch element is also arranged in each sub-pixel, and the switch element is electrically connected to the first electrode 121 of the light-emitting device to control the light-emitting device to emit light. The switch element may be, for example, a thin film transistor. As illustrated in the figure, a thin film transistor T1 is arranged in the first sub-pixel P1, and the thin film transistor T1 is electrically connected to the first electrode 121 of the light-emitting device EL1 to control the light-emitting device EL1 to emit light. A thin film transistor T2 is arranged in the second sub-pixel P2, and the thin film transistor T2 is electrically connected to the first electrode 121 of the light-emitting device EL2 to control the light-emitting device EL2 to emit light. A thin film transistor T3 is arranged in the third sub-pixel P3, and the thin film transistor T3 is electrically connected to the first electrode 121 of the light-emitting device EL3 to control the light-emitting device EL3 to emit light. The light-emitting device EL1 and the thin film transistor T1 are in the light-emitting region LA1 of the first sub-pixel P1, the light-emitting device EL2 and the thin film transistor T2 are in the light-emitting region LA2 of the second sub pixel P2, and the light-emitting device EL3 and the thin film transistor T3 are in the light-emitting region LA3 of the third sub-pixel P3. A non-light-emitting region NLA is arranged between the light-emitting regions LA1 and LA2, and a non-light-emitting region NLA is arranged between the light-emitting regions LA2 and LA3.

The counter substrate 200 comprises a wavelength conversion layer 160, which is on a side of the second electrode 122 of the light-emitting device away from the first electrode 121. The wavelength conversion layer 160 comprises a first wavelength conversion pattern 161, a second wavelength conversion pattern 162 and optionally a light transmission pattern 163. A first wavelength conversion pattern 161 is arranged in the first sub-pixel P1. The first wavelength conversion pattern 161 can convert the light L1 of first wavelength and the light L2 of second wavelength emitted by the light-emitting device EL1 in the first sub-pixel P1 into light of third wavelength, and emit the light of third wavelength toward the second substrate 175. A second wavelength conversion pattern 162 is arranged in the second sub-pixel P2. The second wavelength conversion pattern 162 can convert the light L1 of first wavelength emitted by the light-emitting device EL2 in the second sub-pixel P2 into the light of second wavelength, and emit the light of second wavelength toward the second substrate 175. A light transmission pattern 163 may be arranged in the third sub-pixel P3. The light transmission pattern 163 can transmit the light L1 of first wavelength and the light L2 of second wavelength emitted by the light-emitting device EL3 in the third sub-pixel P3, so that the light L1 of first wavelength and the light L2 of second wavelength are emitted toward the second substrate 175. In an example, the light L1 of first wavelength may be blue light, the light L2 of second wavelength may be green light, and the light of third wavelength may be red light. In this case, the first wavelength conversion pattern 161 converts the blue light L1 and the green light L2 emitted by the light-emitting device EL1 in the first sub-pixel P1 into red light, the second wavelength conversion pattern 162 converts the blue light L1 emitted by the light-emitting device EL2 in the second sub-pixel P2 into green light.

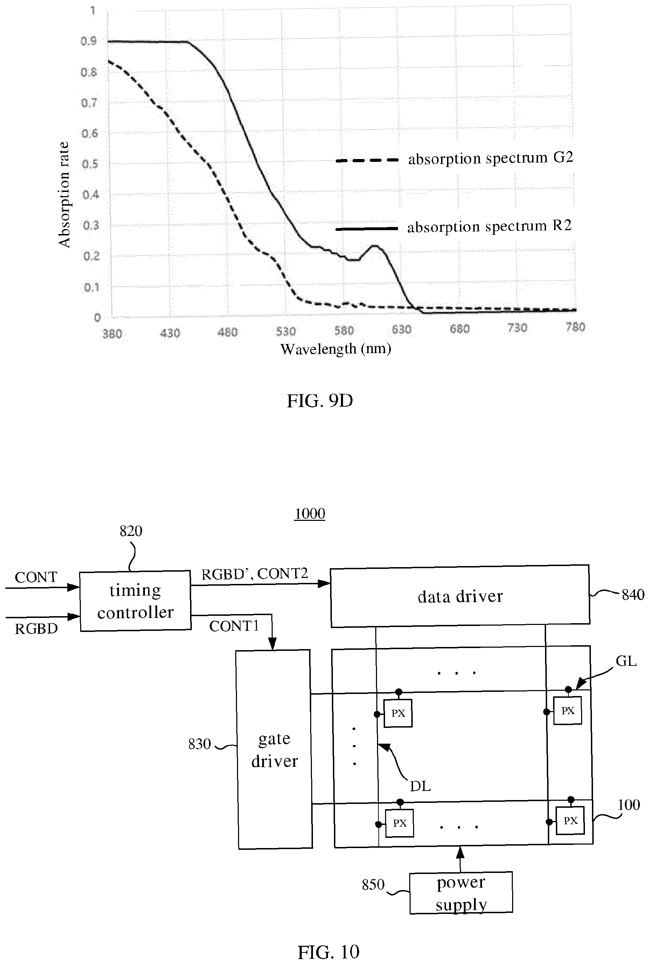

In some embodiments, each of the first wavelength conversion pattern 161 and the second wavelength conversion pattern 162 may comprise a base resin and wavelength conversion particles dispersed in the base resin, and may further comprise scattering particles dispersed in the base resin. The material of the base resin is not particularly limited as long as it has high light transmittance and excellent dispersibility for the wavelength conversion particles and scattering particles. The wavelength conversion particles can convert the peak wavelength of incident light into another specific peak wavelength. In some embodiments, wavelength converting particles may comprise quantum dots, quantum rods, and phosphors. For example, the quantum dot may be particulate matter that emits a particular color when electrons move from the conduction band to the valence band, and the quantum dot may be semiconductor nanocrystalline material. The Quantum dots have a specific band gap according to their composition and size, and thus can absorb light and then emit light with a specific wavelength. Light emitted by the quantum dots has a narrow spectral bandwidth, and thus, color purity and color reproducibility of colors displayed by the display panel 900 may be improved. Also, the light emitted from the quantum dots may be emitted in various directions regardless of the incident direction of the incident light incident on the quantum dots. FIG. 9D illustrates the absorption spectra of the red quantum dots R2 and the green quantum dots G2. It can be seen that when the wavelength is less than 630 nm, the absorption rate of the red quantum dots R2 is greater than that of the green quantum dots G2. In some embodiments, the light transmission pattern 163 may comprise a base resin and scattering particles dispersed in the base resin.

When the wavelength conversion layer 160 comprises quantum dots and the light-emitting layer of the light-emitting device is an organic layer, the display panel 900 is a quantum dot-organic light-emitting diode (QD-OLED) display panel. The technical advantages of QD-OLED display panel lie in high resolution, high color gamut, high color purity, and no viewing angle dependence. Another potential advantage of QD-OLED display panel is that it can be applied to large products/high color gamut products, and is also compatible with medium-sized ultra high definition (UHD) and high-value products. Moreover, the resonant cavity structure of the optical device in the QD-OLED display panel helps to further improve the light-emitting efficiency and color purity of the display panel, and the introduction of quantum dots can also solve the problem of angular deviation.

As illustrated in FIG. 9C, the counter substrate 200 may further comprise a color filter 170 on the side of the wavelength conversion layer 160 away from the first electrode 121, and the color filter 170 comprises a first color filter 171, a second color filter 172, and a third color filter 173. The first color filter 171 is configured to allow transmission of the light of third wavelength, the second color filter 172 is configured to allow the transmission of the light of second wavelength, and the third color filter 173 is configured to allow the transmission of the light of first wavelength. When the light of first wavelength is blue light, the light of second wavelength is green light, and the light of third wavelength is red light, the first color filter 171 is a red color filter, the second color filter 172 is a green color filter, and the third color filter 173 is a blue color filter. The first color filter 171 is in the first sub-pixel P1, the second color filter 172 is in the second sub-pixel P2, and the third color filter 173 is in the third sub-pixel P3. A light-shielding pattern 174 is arranged between the first color filter 171 and the second color filter 172 and between the second color filter 172 and the third color filter 173, and the light-shielding pattern 174 may be, for example, a black matrix BM. The region where the light-shielding pattern 174 is located is a light-shielding region BA, and the light-shielding area BA corresponds to the non-light-emitting region NLA.

As illustrated in FIG. 9C, taking the first sub-pixel P1 as an example, the orthographic projection of the first color filter 171 on the first base substrate 101, the orthographic projection of the first wavelength conversion pattern 161 on the first base substrate 101, and the orthographic projection of the light-emitting region LA1 on the first base substrate 101, at least partially overlap. In some embodiments, the area of the orthographic projection of the first color filter 171 on the first base substrate 101 is larger than the area of the orthographic projection of the light-emitting region LA1 on the first base substrate 101, and the area of the orthographic projection of the first wavelength conversion pattern 161 on the first base substrate 101 is larger than the area of the orthographic projection of the light-emitting region LA1 on the first base substrate 101. The relative positional relationship of the color filter, the wavelength conversion pattern (or light transmission pattern), and the light-emitting region in the second sub-pixel P2 and the third sub-pixel P3 is the same as that of the first sub-pixel P1. For the sake of brevity, the description of the second sub-pixel P2 and the third sub-pixel P3 is not repeated here.

The following describes how the wavelength conversion layer 160 cooperates with the color filter 170 to convert and selectively filter the light emitted by the light-emitting device, so as to obtain higher-purity emitted light of a desired color.

Referring to the first sub-pixel P1, the first wavelength conversion pattern 161 may convert the blue light L1 and the green light L2 emitted by the light-emitting device EL1 into red light and emit the red light toward the first color filter 171. The red light is transmitted through the first color filter 171 and emitted to the outside of the display panel 900. In an actual process, the blue light L1 and the green light L2 emitted by the light-emitting device EL1 may not be completely converted by the first wavelength conversion pattern 161, and the light not converted by the first wavelength conversion pattern 161 is directly transmitted through the first wavelength conversion pattern 161 and emitted toward the first color filter 171. The blue light and/or green light incident on the first color filter 171 without being converted by the first wavelength conversion pattern 161 is blocked and absorbed by the first color filter 171. Therefore, the first color filter 171 can ensure that the color of the emitted red light is purer. Finally, the first emitted light LR emitted from the first sub-pixel P1 to the outside of the display panel 900 is red light.

Referring to the second sub-pixel P2, the second wavelength conversion pattern 162 may convert the blue light L1 emitted by the light-emitting device EL2 into green light and emit the green light toward the second color filter 172, and the green light L2 emitted by the light-emitting device EL2 is directly transmitted through the second wavelength conversion pattern 162 and emitted toward the second color filter 172. The green light converted by the second wavelength conversion pattern 162 and the green light transmitted through the second wavelength conversion pattern 162 are emitted to the outside of the display panel 900 through the second color filter 172. In the actual process, the blue light L1 emitted by the light-emitting device EL2 may not be completely converted by the second wavelength conversion pattern 162, and the blue light not converted by the second wavelength conversion pattern 162 is directly transmitted through the second wavelength conversion pattern 162 and emitted toward the second color filter 172. The blue light incident on the second color filter 172 without being converted by the second wavelength conversion pattern 162 is blocked and absorbed by the second color filter 172. Therefore, the second color filter 172 can ensure that the color of the emitted green light is purer. Finally, the second emitted light LG emitted from the second sub-pixel P2 to the outside of the display panel 900 is green light.

Referring to the third sub-pixel P3, the blue light L1 and the green light L2 emitted by the light-emitting device EL3 are transmitted through the light transmission pattern 163 and incident on the third color filter 173. The blue light L1 incident on the third color filter 173 is transmitted through the third color filter 173 and emitted toward the outside of the display panel 900. The green light L2 incident on the third color filter 173 is blocked or absorbed by the third color filter 173. Therefore, the third color filter 173 can ensure that the color of the emitted blue light is purer. Finally, the third emitted light LB emitted from the third sub-pixel P3 to the outside of the display panel 900 is blue light.

By emitting red light from the first sub-pixel P1, green light from the second sub-pixel P2 and blue light from the third sub-pixel P3, the display panel 900 can emit white light.

It should be noted that the light conversion efficiency of the second wavelength conversion pattern 162 for converting blue light into green light is generally lower than the light conversion efficiency of the first wavelength conversion pattern 161 for converting blue light (and green light) into red light. Therefore, if each light-emitting device comprises only the same number of blue light-emitting layers as in the related art, when the same amount of blue light is provided to the first wavelength conversion pattern 161 and the second wavelength conversion pattern 162, the light amount of the green light emitted from the second sub-pixel P2 will be less than the light amount of the red light emitted from the first sub-pixel P1, resulting in a lower brightness of the green light emitted from the second sub-pixel P2. However, in the embodiments of the present application, each light-emitting device (especially the light-emitting device EL2 in the second sub-pixel P2) comprises three blue light-emitting layers and one green light-emitting layer (when the light-emitting device comprises five light-emitting layers, at least three light-emitting layers are blue light-emitting layers, and the remaining light-emitting layers are green light-emitting layers). The light-emitting device EL2 in the second sub-pixel P2 emits blue light L1 and green light L2, the green light L2 and the green light converted by the second wavelength conversion pattern 162 (the blue light L1 is converted into green light) together act as the second light LG and are emitted to the outside of the second sub-pixel P2. Therefore, the green light L2 may serve as a supplement to the green light converted by the second wavelength conversion pattern 162. With such a design, the light amount of the green light emitted from the second sub-pixel P2 can be increased, thereby increasing the brightness of the green light emitted from the second sub-pixel P2. According to calculations, compared with a display panel comprising a light-emitting device composed of four blue light-emitting layers, the power consumption of white light emitted by the display panel 900 provided in the embodiment of the present application can be reduced by about 20%.

For the sake of clarity, only some components of the display panel 900 are illustrated in the figure, but as known to those skilled in the art, in order to realize the display function and other necessary functions of the display panel 900, the display panel 900 may also comprise any other suitable components.

For other technical effects of the display panel 900, reference may be made to the technical effects of the light-emitting device described in the previous embodiments, therefore, for the sake of brevity, description is not repeated here.

Still another aspect of the present disclosure provides a display device. FIG. 10 illustrates a block diagram of a display device 1000. The display device 1000 comprises the light-emitting substrate 100 or the display panel 900 described in any one of the preceding embodiments, a driving circuit electrically connected to the light-emitting substrate 100 and configured to provide a driving signal to the display device 1000, and a power supply circuit electrically connected to the light-emitting substrate 100 and configured to provide a voltage signal to the display device 1000. The display device 1000 may be any product or component with a display function, such as a mobile phone, a tablet computer, a television, a monitor, a notebook computer, a digital photo frame, a navigator, and the like.

Referring to FIG. 10, the display device 1000 comprises the light-emitting substrate 100, a timing controller 820, a gate driver 830, a data driver 840 and a power supply 850.

The light-emitting substrate 100 is an array substrate. The light-emitting substrate 100 comprises a plurality of gate lines GL and a plurality of data lines DL crossing each other. The light-emitting substrate 110 comprises a plurality of sub-pixels PX arranged in an array, and each sub-pixel PX is provided with any one of the aforementioned light-emitting devices 110, 210, 310, 410, 510, 610, 710, 810. Each sub-pixel PX may be electrically connected to a corresponding one of the gate lines GL and a corresponding one of the data lines DL. Each sub-pixel PX may take the arrangement of sub-pixels described with respect to FIG. 9C.

The timing controller 820 controls operations of the light-emitting substrate 100, the gate driver 830 and the data driver 840. The timing controller 820 receives input image data RGBD and an input control signal CONT from an external device (e.g., a host). The timing controller 820 generates output image data RGBD', a first control signal CONT1 and a second control signal CONT2 based on the input image data RGBD and the input control signal CONT. The timing controller 820 may generate the first control signal CONT1 based on the input control signal CONT. The first control signal CONT1 may be provided to the gate driver 830, and the driving timing of the gate driver 830 may be controlled based on the first control signal CONT1. The timing controller 820 may generate the second control signal CONT2 based on the input control signal CONT. The second control signal CONT2 may be provided to the data driver 840, and the driving timing of the data driver 840 may be controlled based on the second control signal CONT2.

The gate driver 830 receives the first control signal CONT1 from the timing controller 820. The gate driver 830 generates a plurality of gate signals for driving the gate lines GL based on the first control signal CONT1. The gate driver 830 may sequentially apply the plurality of gate signals to the gate lines GL.

The data driver 840 receives the second control signal CONT2 and the output image data RGBD' from the timing controller 820. The data driver 840 generates a plurality of data voltages based on the second control signal CONT2 and the output image data RGBD'. The data driver 840 may apply the plurality of data voltages to the data lines DL.

The power supply 850 supplies power to the sub-pixels PX in the light-emitting substrate 100. For clarity of illustration, power supply lines connected to the sub-pixels PX are not illustrated in FIG. 10. In some embodiments, the power supply 850 can also supply power to the timing controller 820, the gate driver 830 and the data driver 840.

As known to those skilled in the art, in order to realize the display function and other necessary functions of the display device 1000, the display device 1000 may further comprise any other appropriate components.

Since the technical effects of the display device 1000 can refer to the technical effects of the light-emitting device and the display panel 900 described in the previous embodiments, for the sake of brevity, description is not repeated here.

It will be understood that although the terms first, second, third, etc. may be used herein to describe various elements, components, regions, layers and/or portions, these elements, components, regions, layers and/or portions should not be limited by these terms. These terms are only used to distinguish an element, component, region, layer or portion from another element, component, region, layer or portion. Thus, a first element, component, region, layer or portion discussed above could be termed a second element, component, region, layer or portion without departing from the teachings of the present disclosure.

Spatially relative terms such as "row", "column", "below", "above", "left", "right", etc. may be used herein for ease of description to describe factors such as the relationship of an element or feature to another element(s) or feature(s) illustrated in the figures. It will be understood that these spatially relative terms are intended to encompass different orientations of the device in use or operation in addition to the orientation depicted in the figures. For example, if the device in the figures is turned over, elements described as "below" other elements or features would then be oriented "above" other elements or features. Thus, the exemplary term "below" can encompass both an orientation of above and below. The device may be otherwise oriented (rotated 90 degrees or at other orientations) and the spatially relative descriptors used herein are interpreted accordingly. In addition, it will also be understood that when a layer is referred to as being "between" two layers, it can be the only layer between the two layers, or one or more intervening layers may also be present.

The terminology used herein is for the purpose of describing particular embodiments only and is not intended to limit the present disclosure. As used herein, the singular forms "a," "an," and "the" are intended to comprise the plural forms as well, unless the context clearly dictates otherwise. It will be further understood that the terms "comprise" and/or "include" when used in this specification designate the presence of stated features, integers, steps, operations, elements and/or parts, but do not exclude the presence or addition of one or more other features, integers, steps, operations, elements, components and/or groups thereof. As used herein, the term "and/or" comprises any and all combinations of one or more of the associated listed items. In the description of this specification, description with reference to the terms "an embodiment," "another embodiment," etc. means that a particular feature, structure, material, or characteristic described in connection with the embodiment is included in at least one embodiment of the present disclosure. In this specification, schematic representations of the above terms are not necessarily directed to the same embodiment or example. Furthermore, the particular features, structures, materials or characteristics described may be combined in any suitable manner in any one or more embodiments or examples. Furthermore, those skilled in the art may combine the different embodiments or examples as well as the features of the different embodiments or examples described in this specification without conflicting each other.

It will be understood that when an element or layer is referred to as being "on", "connected to", "coupled to", or "adjacent to" another element or layer, it may be directly on, directly connected to, directly coupled to, or directly adjacent to another element or layer, or intervening elements or layers may be present. In contrast, when an element is referred to as being "directly on", "directly connected to", "directly coupled to", "directly adjacent to" another element or layer, with no intervening elements or layers present. However, in no case should "on" or "directly on" be interpreted as requiring a layer to completely cover the layer below.

Embodiments of the disclosure are described herein with reference to schematic illustrations (and intermediate structures) of idealized embodiments of the disclosure. As such, variations to the shapes of the illustrations are to be expected, e.g., as a result of manufacturing techniques and/or tolerances. Accordingly, embodiments of the present disclosure should not be construed as limited to the particular shapes of the regions illustrated herein, but are to comprise deviations in shapes due, for example, to manufacturing. Thus, the regions illustrated in the figures are schematic in nature and their shapes are not intended to illustrate the actual shape of a region of a device and are not intended to limit the scope of the present disclosure.

Unless otherwise defined, all terms (comprising technical and scientific terms) used herein have the same meaning as commonly understood by one of ordinary skill in the art to which this disclosure belongs. It will be further understood that terms such as those defined in commonly used dictionaries should be construed to have meanings consistent with their meanings in the relevant art and/or the context of this specification, and will not be idealized or overly interpreted in a formal sense, unless expressly defined as such herein.

The above descriptions are merely specific embodiments of the present disclosure, but the protection scope of the present disclosure is not limited thereto. Any changes or substitutions that those skilled in the art can easily think of within the technical scope disclosed by the present disclosure, should be comprised within the protection scope of the present disclosure. Therefore, the protection scope of the present disclosure should be based on the protection scope of the claims.

**Claims**

1. A light-emitting substrate comprising a plurality of light-emitting devices arranged in an array, wherein each light-emitting device of the plurality of light-emitting devices comprises:

   a first electrode;
   a first light-emitting layer on the first electrode;
   a second light-emitting layer on a side of the first light-emitting layer away from the first electrode;
   a third light-emitting layer on a side of the second light-emitting layer away from the first electrode;
   a fourth light-emitting layer on a side of the third light-emitting layer away from the first electrode; and
   a second electrode on a side of the fourth light-emitting layer away from the first electrode,
   wherein three light-emitting layers of the first light-emitting layer, the second light-emitting layer, the third light-emitting layer, and the fourth light-emitting layer emit light of a first wavelength, a remaining light-emitting layer of the first light-emitting layer, the second light-emitting layer, the third light-emitting layer, and the fourth light-emitting layer except the three light-emitting layers emits light of a second wavelength, and the first wavelength is smaller than the second wavelength.

2. The light-emitting substrate according to claim 1, wherein a ratio of the first wavelength to the second wavelength is in a range of 0.82-0.84.

3. The light-emitting substrate according to claim 1, wherein the first wavelength and the second wavelength satisfy the following formula:

$$\frac{2nL}{\lambda_1} - \frac{2nL}{\lambda_2} = 1$$

   wherein a plurality of layers are arranged between the first electrode and the second electrode, n is an effective refractive index of the plurality of layers, L is a first distance between the first electrode and the second electrode, $\lambda_1$ is the first wavelength, and $\lambda_2$ is the second wavelength.

4. The light-emitting substrate according to claim 1, wherein the first wavelength satisfies the following formula:

$$\sum_{1}^{M} n_i d_i = \frac{\lambda_1}{2}$$

   wherein M layers are arranged between the first electrode and the second electrode, $n_i$ is an effective refractive index of the $i^{th}$ layer in the M layers, $d_i$ is a thickness of the $i^{th}$ layer in the M layers, $\lambda_1$ is the first wavelength, $1 \leq i \leq M$ and i is a positive integer.

5. The light-emitting substrate according to any one of claims 1-4, wherein the light of the first wavelength emitted by the three light-emitting layers forms a first standing wave in the light-emitting device, and the light of the second wavelength emitted by the remaining light-emitting layer forms a second standing wave in the light-emitting device.

6. The light-emitting substrate according to claim 5, wherein a second distance between a surface of the first electrode facing the first light-emitting layer and a light-emitting center of the first light-emitting layer is greater than or equal to 100 nm.

7. The light-emitting substrate according to claim 6, wherein the first light-emitting layer, the second light-emitting layer, and the third light-emitting layer emit blue light, and the fourth light-emitting layer emits green light.

8. The light-emitting substrate according to claim 7, wherein the surface of the first electrode facing the first light-emitting layer is taken as a reference plane, the first light-emitting layer is at the second antinode of the first standing wave, the second light-emitting layer is at the third antinode of the first standing wave, the third light-emitting layer is at the fourth antinode of the first standing wave, and the fourth light-emitting layer is at the fourth antinode of the second standing wave.

9. The light-emitting substrate according to claim 7 or 8, wherein the second distance is 115-135 nm.

10. The light-emitting substrate according to claim 6, wherein the first light-emitting layer emits green light, and the second light-emitting layer, the third light-emitting layer, and the fourth light-emitting layer emit blue light.

11. The light-emitting substrate according to claim 10, wherein the surface of the first electrode facing the first light-emitting layer is taken as a reference plane, the first light-emitting layer is at the second antinode of the second standing wave, the second light-emitting layer is at the third antinode of the first standing wave, the third light-emitting layer is at the fourth antinode of the first standing wave, and the fourth light-emitting layer is at the fifth antinode of the first standing wave.

12. The light-emitting substrate according to claim 6, wherein the first light-emitting layer, the second light-emitting layer, and the fourth light-emitting layer emit blue light, and the third light-emitting layer emits green light.

13. The light-emitting substrate according to claim 12, wherein the surface of the first electrode facing the first light-emitting layer is taken as a reference plane, the first light-emitting layer is at the second antinode of the first standing wave, the second light-emitting layer is at the third antinode of the first standing wave, the fourth light-emitting layer is at the fifth antinode of the first standing wave, and a distance between the third light-emitting layer and the third antinode of the second standing wave is 10-30 nm.

14. The light-emitting substrate according to claim 5, wherein a second distance between a surface of the first electrode facing the first light-emitting layer and a light-emitting center of the first light-emitting layer is less than 100 nm.

15. The light-emitting substrate according to claim 14, wherein the first light-emitting layer, the second light-emitting layer, and the third light-emitting layer emit blue light, and the fourth light-emitting layer emits green light.

16. The light-emitting substrate according to claim 15, wherein the surface of the first electrode facing the first light-emitting layer is taken as a reference plane, the first light-emitting layer is at the first antinode of the first standing wave, the second light-emitting layer is at the third antinode of the first standing wave, the third light-emitting layer is at the fourth antinode of the first standing wave, and the fourth light-emitting layer is at the fourth antinode of the second standing wave.

17. The light-emitting substrate according to claim 14, wherein the first light-emitting layer, the second light-emitting layer, and the fourth light-emitting layer emit blue light, and the third light-emitting layer emits green light.

18. The light-emitting substrate according to claim 17, wherein the surface of the first electrode facing the first light-emitting layer is taken as a reference plane, the first light-emitting layer is at the first antinode of the first standing wave, the second light-emitting layer is at the third antinode of the first standing wave, the fourth light-emitting layer is at the fifth antinode of the first standing wave, and a distance between the third light-emitting layer and the third antinode of the second standing wave is 10-30 nm.

19. The light-emitting substrate according to claim 14, wherein the first light-emitting layer emits green light, and the second light-emitting layer, the third light-emitting layer, and the fourth light-emitting layer emit blue light.

20. The light-emitting substrate according to claim 19, wherein the surface of the first electrode facing the first light-emitting layer is taken as a reference plane, the first light-emitting layer is at the first antinode of the second standing wave, the second light-emitting layer is at the third antinode of the first standing wave, the third light-emitting layer is at the fourth antinode of the first standing wave, and the fourth light-emitting layer is at the fifth antinode of the first standing wave.

21. The light-emitting substrate according to any one of claims 5-20, wherein a first distance between the first electrode and the second electrode is 500-550 nm.

22. The light-emitting substrate according to claim 21, wherein the first distance is equal to 5 times the distance between two adjacent antinodes of the first standing wave or 4 times the distance between two adjacent antinodes of the second standing wave.

23. The light-emitting substrate according to any one of claims 1-22, wherein a thickness of each of the three light-emitting layers that emit the light of the first wavelength among the first light-emitting layer, the second light-emitting layer, the third light-emitting layer, and the fourth light-emitting layer is 20-25 nm, and a thickness of the light-emitting layer emitting the light of the second wavelength among the first light-emitting layer, the second light-emitting layer, the third light-emitting layer and the fourth light-emitting layer is 30-35 nm.

24. The light-emitting substrate according to any one of claims 1-23, wherein the first electrode is an anode and the second electrode is a cathode, and the first electrode is reflective and the second electrode is transmissive and reflective.

25. The light-emitting substrate according to claim 24, wherein a full width at half maximum of both the light of the first wavelength and the light of the second wavelength satisfies the following formula:

$$FWHM = \frac{\lambda^2}{2L} \frac{(1 - x^2)}{2Lx\pi}, \quad x = f(R_1, R_2)$$

wherein $\lambda$ is the first wavelength or the second wavelength, $L$ is a first distance between the first electrode and the second electrode, $R_1$ is a reflectivity of the second electrode, $R_2$ is a reflectivity of the first electrode, $x$ is a function of $R_1$ and $R_2$.

26. The light-emitting substrate according to claim 25, wherein

$$x = (R_1 R_2)^{1/4}.$$

27. The light-emitting substrate according to any one of claims 1-26, wherein each light-emitting device of the plurality of light-emitting devices further comprises a first charge generation layer between the first light-emitting layer and the second light-emitting layer, a second charge generation layer between the second light-emitting layer and the third light-emitting layer, and a third charge generation layer between the third light-emitting layer and the fourth light-emitting layer.

28. The light-emitting substrate according to any one of claims 1-27, further comprising a fifth light-emitting layer between the fourth light-emitting layer and the second electrode, wherein the fifth light-emitting layer emits the light of the first wavelength or the light of the second wavelength.

29. The light-emitting substrate according to any one of claims 1-28, wherein the light-emitting device is an organic light-emitting diode.

30. A display panel comprising the light-emitting substrate according to any one of claims 1-29 and a plurality of sub-pixels arranged in an array, wherein each of the plurality of sub-pixels is provided with the light-emitting device.

31. The display panel according to claim 30, further comprising a wavelength conversion layer on a side of the second electrode away from the first electrode, wherein,

the wavelength conversion layer comprises a plurality of first wavelength conversion patterns and a plurality of second wavelength conversion patterns,
the plurality of sub-pixels comprise a plurality of first sub-pixels, a plurality of second sub-pixels and a plurality of third sub-pixels,
each of the plurality of first sub-pixels is provided with a first wavelength conversion pattern, the first wavelength conversion pattern is configured to convert the light of the first wavelength and the light of the second wavelength emitted by the light-emitting device in the first sub-pixel into light of a third wavelength, and,
each of the plurality of second sub-pixels is provided with a second wavelength conversion pattern, the second wavelength conversion pattern is configured to convert the light of the first wavelength emitted by the light-emitting device in the second sub-pixel into the light of the second wavelength.

**32.** The display panel according to claim 31, wherein a material of the wavelength conversion layer comprises quantum dots.

**33.** The display panel according to claim 31 or 32, further comprising a color filter on a side of the wavelength conversion layer away from the first electrode,

wherein the color filter comprises a plurality of first color filters, a plurality of second color filters and a plurality of third color filters,

each of the plurality of first sub-pixels is provided with a first color filter, the first color filter is configured to allow transmission of the light of the third wavelength;

each of the plurality of second sub-pixels is provided with a second color filter, the second color filter is configured to allow transmission of the light of the second wavelength; and

each of the plurality of third sub-pixels is provided with a third color filter, the third color filter is configured to allow transmission of the light of the first wavelength.

**34.** A display device comprising:

the light-emitting substrate according to any one of claims 1-29 or the display panel according to any one of claims 30-33;

a driving circuit electrically connected to the light-emitting substrate and configured to provide a driving signal to the display device; and

a power supply circuit electrically connected to the light-emitting substrate and configured to provide a voltage signal to the display device.

100

110

FIG. 1A

110

L1    L2

122

134

133

132

131

121

FIG. 1B

210

L1       L2

142 — 
122 — 
141 — 
234 —   W24
153 — 
233 — W14
152 — 
232 — W13
151 — 
231 — W12
121 — 

W1    W2

X2

X1

FIG. 2A

FIG. 2B

FIG. 2C

FIG. 3A

FIG. 3B

FIG. 3C

## 410

FIG. 4A

FIG. 4B

FIG. 4C

510

L1    L2

142
122
141
534 ......W24
153
533 ← - - → W14
152
532 ......W13
151
531 ......W1....W11....W2
121

X2

X1

FIG. 5A

FIG. 5B

FIG. 5C

FIF. 6A

FIG. 6B

FIG. 6C

<u>710</u>

FIG. 7A

FIG. 7B

FIG. 7C

FIG. 8A

Number of the stacked light-emitting layers in the light-emitting device (U)

FIG. 8B

FIG. 9A

900

NDA | DA | NDA

| | 200 |
| | 180 |
| | 100 |

A | A'

FIG. 9B

900

LR | LG | LB

BA | BA | BA | BA

P1 | P2 | P3

171 170 161 160 | 172 | 162 | 173 | 163

200 | 175 | 174

100 | 101

L1 L2 | L1 L2 | L1 L2

121 EML 122 | 121 EML 122 | 121 EML 122

T1 | T2 | T3

EL1 | EL2 | EL3

NLA | LA1 | NLA | LA2 | NLA | LA3 | NLA

FIG. 9C

FIG. 9D

FIG. 10

<table>
<tr><td colspan="2">**INTERNATIONAL SEARCH REPORT**</td><td>International application No.<br>**PCT/CN2022/093768**</td></tr>
</table>

**A. CLASSIFICATION OF SUBJECT MATTER**

H01L 27/32(2006.01)i;  H01L 51/52(2006.01)i

According to International Patent Classification (IPC) or to both national classification and IPC

**B. FIELDS SEARCHED**

Minimum documentation searched (classification system followed by classification symbols)

H01L

Documentation searched other than minimum documentation to the extent that such documents are included in the fields searched

Electronic data base consulted during the international search (name of data base and, where practicable, search terms used)

CNABS; VEN; CNTXT; USTXT; WOTXT; EPTXT; CNKI: 第四发光, 第n发光, 第m发光, 第i发光, 第k发光, 电荷生成, 电荷产生, 电荷发生, 蓝, 绿, 反射率, 驻波, 节点, 距离, 厚, 波长, display, wavelength, conversion, position, inorganic, refractive, index, light, emitting, encapsulation

**C. DOCUMENTS CONSIDERED TO BE RELEVANT**

| Category* | Citation of document, with indication, where appropriate, of the relevant passages | Relevant to claim No. |
|---|---|---|
| X | CN 113838993 A (SAMSUNG DISPLAY CO., LTD.) 24 December 2021 (2021-12-24) description, paragraphs [0006]-[0387], and figures 1-26 | 1-7, 9, 10, 12, 14, 15, 17, 19, 21-24, 27-34 |
| X | CN 114207859 A (DUK SAN NEOLUX CO., LTD.) 18 March 2022 (2022-03-18) description, paragraphs [0422]-[0439], and figures 1-5 | 1-7, 9, 10, 12, 14, 15, 17, 19, 21-24, 27-34 |
| X | CN 110115107 A (LUMIOTEC INC.) 09 August 2019 (2019-08-09) description, paragraphs [0008]-[0181], and figures 1-17 | 1-5, 14, 21-24, 27-34 |
| A | US 2014203273 A1 (PANASONIC CORP.) 24 July 2014 (2014-07-24) entire document | 1-34 |

☐ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **24 November 2022** | **13 December 2022** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

<div align="center">

**INTERNATIONAL SEARCH REPORT**
**Information on patent family members**

</div>

| International application No. |
| --- |
| **PCT/CN2022/093768** |

| Patent document cited in search report | | | Publication date (day/month/year) | Patent family member(s) | | | Publication date (day/month/year) |
| --- | --- | --- | --- | --- | --- | --- | --- |
| CN | 113838993 | A | 24 December 2021 | US | 2021408476 | A1 | 30 December 2021 |
| | | | | KR | 102333517 | B1 | 01 December 2021 |
| | | | | KR | 20220000388 | A | 03 January 2022 |
| CN | 114207859 | A | 18 March 2022 | WO | 2021025372 | A1 | 11 February 2021 |
| | | | | KR | 20210015615 | A | 10 February 2021 |
| | | | | KR | 20210015643 | A | 10 February 2021 |
| CN | 110115107 | A | 09 August 2019 | US | 2019319209 | A1 | 17 October 2019 |
| | | | | JP | 6155378 | B1 | 28 June 2017 |
| | | | | WO | 2018124238 | A1 | 05 July 2018 |
| | | | | JP | 2018107032 | A | 05 July 2018 |
| | | | | US | 11024822 | B2 | 01 June 2021 |
| | | | | CN | 110115107 | B | 21 December 2021 |
| US | 2014203273 | A1 | 24 July 2014 | DE | 112012003937 | T5 | 17 July 2014 |
| | | | | WO | 2013042745 | A1 | 28 March 2013 |

Form PCT/ISA/210 (patent family annex) (January 2015)